(19) Europäisches Patentamt
European Patent Office
Office européen des brevets

(11) EP 1 721 740 A1

(12) # EUROPEAN PATENT APPLICATION
published in accordance with Art. 158(3) EPC

(43) Date of publication:
**15.11.2006 Bulletin 2006/46**

(21) Application number: **05719697.4**

(22) Date of filing: **01.03.2005**

(51) Int Cl.:
***B32B 27/34*** (2006.01) ***B32B 15/08*** (2006.01)
***H05K 1/03*** (2006.01)

(86) International application number:
**PCT/JP2005/003380**

(87) International publication number:
**WO 2005/084948 (15.09.2005 Gazette 2005/37)**

(84) Designated Contracting States:
**AT BE BG CH CY CZ DE DK EE ES FI FR GB GR HU IE IS IT LI LT LU MC NL PL PT RO SE SI SK TR**

(30) Priority: **04.03.2004 JP 2004060234**

(71) Applicant: **TORAY INDUSTRIES, INC.**
**Tokyo 103-8666 (JP)**

(72) Inventors:
- **WATANABE, Takuo**
**Otsu-shi, Shiga 520-2144 (JP)**
- **MATSUMOTO, Yu**
**Otsu-shi, Shiga 520-0842 (JP)**

(74) Representative: **Coleiro, Raymond et al**
**MEWBURN ELLIS**
**York House**
**23 Kingsway**
**London WC2B 6HP (GB)**

(54) **HEAT-RESISTANT RESIN LAMINATED FILM, MULTILAYER FILM WITH METAL LAYER INCLUDING SAME, AND SEMICONDUCTOR DEVICE**

(57) Disclosed are a heat-resistant resin laminate film comprising a heat-resistant insulating film such as a polyimide film and a heat-resistant resin layer laminated thereon, which laminate film is free from warp; and a laminate film with a metal layer, comprising a heat-resistant insulating film and a metal layer laminated thereon through a heat-resistant resin layer, which laminate film with a metal layer is free from warp in the state that a circuit pattern is formed. In the heat-resistant resin laminate film, a heat-resistant resin layer is laminated on at least one surface of the heat-resistant insulating film, wherein the heat-resistant resin layer has a coefficient of linear expansion kA (ppm/°C) within the range of $k-10 \leq kA \leq k+20$ (k: coefficient of linear expansion of the heat-resistant insulating film). The laminate film with a metal layer is one obtained by laminating the metal layer on the heat-resistant resin layer of the heat-resistant resin laminate film.

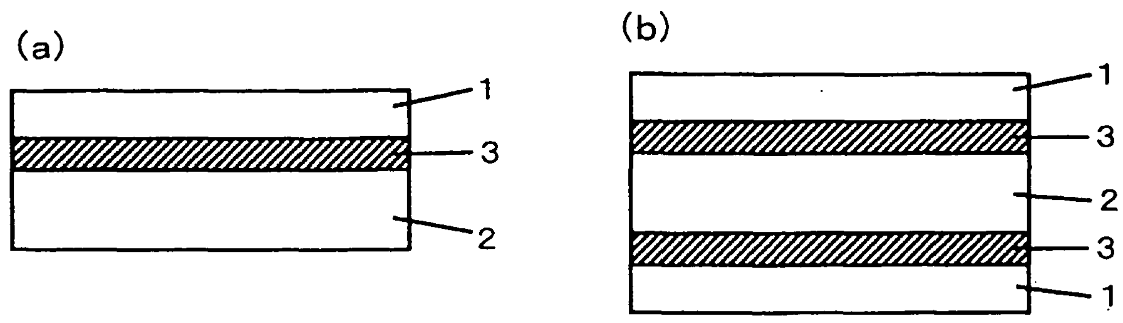


Fig.1

EP 1 721 740 A1

**Description**

Technical Field

The present invention relates to a heat-resistant resin laminate film, and to a laminate film with a metal layer (s) and a semiconductor device comprising the same. More particularly, the present invention relates to a process of producing laminate films with a metal layer(s) for flexible printed circuit boards (FPC) widely used in the field of electronics, and relates to a laminate film with a metal layer(s) used in tape automated bonding (TAB) which is a mounting method of semiconductor integrated circuits (IC), chip on film (COF) and the like, as well as to a semiconductor device using the same and to a process of producing laminate films with a metal layer(s).

Background Art

In recent years, compaction and weight saving of electronic devices are accelerated. In the field of semiconductor integrated circuits too, densification and performance improvement thereof proceed, and miniaturization and performance improvement of circuit patterns are demanded.

Conventionally, TAB is used as a mounting method of the semiconductor integrated circuits. As the circuit boards for FPCs to be mounted by TAB, "trilayer laminate" products comprising a flexible heat-resistant insulating film such as a polyimide film and a copper foil laminated thereon through an adhesive layer such as an epoxy resin, are used.

In TAB, since the inner lead for mounting IC has a flying lead structure, the technical limit of miniaturization is said to be about 40 $\mu$m pitch due to the reduction of strength accompanied by the thinning of the leads and due to the reduction of thickness of the copper foils. In place of TAB, COF method in which the inner lead is formed on a heat-resistant insulating film and is mounted by the flip chip (FC) technique is now prevailing. In TAB, an IC is directly bonded to copper wirings having the flying lead structure, while in COF, an IC is bonded to copper wirings on the heat-resistant insulating film, so that the heat during the bonding is exerted also to the heat-resistant insulating film.

In the "trilayer laminate" products conventionally used in TAB or general FPC, since the adhesive used therein is based on an epoxy resin, phenol resin, acrylonitrile resin, butadiene resin or the like, whose heat resistance is poorer than that of polyimide used for the heat-resistant insulating film, the excellent characteristics of the polyimide film are not fully exploited. Particularly, in many cases in the bonding of IC by the COF method, tin-plated wirings and gold bumps of the IC are collectively bonded (gang bonding of Au-Sn eutectic mixture), and with this method, the heat and pressure during the bonding are directly exerted to the adhesive layer. In general, the adhesive layer is subjected to a temperature at 300°C to 400°C, and a pressure of 0.2 to 0.3N is exerted to one bump in order to uniformly bond the wirings and the gold bumps. When an FPC board using the above-mentioned resin as the adhesive layer is subjected to bonding under these conditions, the wirings are largely embedded into the adhesive layer due to thermal decomposition or the like of the adhesive layer, and problems such as the cutting of the wirings occur. Further, since impurity ions are contained in the above-described resins, there is also a problem of reduction of insulation reliability, so that they are not suitable as materials for COF.

As the FPC boards for COF, "bilayer type" is now widely used, which does not use an adhesive. The bilayer type includes "bilayer plated" products produced by forming an conductive metal layer on a heat-resistant insulating film such as a polyimide film by vacuum evaporation, sputtering, ion plating, plating or the like, and "bilayer cast" products produced by coating a copper foil with a resin to form a heat-resistant insulating layer.

With the "bilayer plated" products, since a metal layer such as a copper layer is directly formed on the heat-resistant insulating film which is a substrate, the type of the substrate and the thickness of the metal layer may be freely selected. However, there is a problem in that the adhesion between the metal layer and the film is poor. Further, there are also problems in that pinholes are likely to be formed and so it is difficult to promote the productivity, so that the production cost is high. With the "bilayer cast" products, while the adhesion between the metal layer and the film is good, since they are produced by coating a copper foil with the heat-resistant resin layer, the copper foil is shrunk or waved due to the volume shrinkage and thermal contraction during the drying and curing, when the copper foil is thin. Thus, they have a problem in quality. Especially, when the thickness of the copper foil is not more than 12 $\mu$m, the operativity is further deteriorated, and the productivity is lowered, which is problematic.

In recent years, "trilayer laminate" products in which a polyimide resin is used as the adhesive layers are studied. Since the "trilayer laminate" products are produced by laminating a commercially available copper foil and a base film such as a polyimide film, they are cost advantageous.

Circuit boards for FPC, called "pseudo bilayer product" have been proposed, which are produced by laminating a multilayer aromatic polyimide film and a metal foil such as a copper foil, which multilayer aromatic polyimide film comprises a core made of a polyimide resin having a rigid structure and thermoplastic polyimide resin layers laminated on the surfaces thereof, and heat pressing the resulting laminate (see, for example, Patent Literatures 1 and 2). Although these boards for FPC have a good adhesion with the metal foils, they are used only in the form of double-sided copper

clad laminate. If they are used in the form of a single-sided copper clad laminate, there is a problem in that the circuit board is largely warped when the copper layer is etched, that is, in the state that the circuit pattern is formed. Further, even with the double-sided copper clad laminate, if there is a difference between the film thicknesses of the thermoplastic polyimide resin layers formed on the both sides of the core polyimide resin layer, warp is generated.

A board for FPC comprising a metal layer formed on a surface of a polyimide film via a thermoplastic polyimide resin layer, and a heat-resistant polyimide layer formed on the opposite side of the polyimide film has been proposed (see, for example, Patent Literatures 3 and 4). By employing such a structure, the warp of the board after etching of the copper layer may be reduced. However, the number of production steps is increased, so that the productivity is problematic.

Patent Literature 1: Japanese Laid-open Patent Application (Kokai) No. 9-99518 (pages 2-7)
Patent Literature 2: Japanese Laid-open Patent Application (Kokai) No. 2002-114848(pages 6-8)
Patent Literature 3: Japanese Laid-open Patent Application (Kokai) No. 9-148695 (pages 2-7)
Patent Literature 4: Japanese Laid-open Patent Application (Kokai) No. 2000-96010 (pages 3-7)

Disclosure of the Invention

Problems Which the Invention Tries to Solve

In view of these circumstances, an object of the present invention is to provide a heat-resistant resin laminate film comprising a heat-resistant insulating film such as a polyimide film and a heat-resistant resin layer laminated thereon, which is free from warping. Another object of the present invention is to provide a laminate film with a metal layer(s) comprising a heat-resistant insulating film and a metal foil laminated thereon through a heat-resistant resin layer, which is free from warping when the copper layer is etched, that is, in the state that the circuit pattern is formed, and to provide a highly reliable semiconductor device using it.

Means for Solving the Problems

That is, the present invention provides a heat-resistant resin laminate film comprising a heat-resistant insulating film, and a heat-resistant resin layer(s) laminated on at least one surface of the heat-resistant insulating film, the heat-resistant resin layer having a coefficient of linear expansion kA (ppm/°C) within the range of $k-10 \leq kA \leq k+20$ (wherein k represents the coefficient of linear expansion of the heat-resistant insulating film), and also provides a laminate film having a metal layer(s) comprising the above-described heat-resistant resin laminate film, and a metal layer(s) laminated on the heat-resistant resin layer(s). The present invention further provides a heat-resistant resin laminate film according to claim 1, comprising a heat-resistant insulating film, and a heat-resistant resin layer(s) laminated on at least one surface of the heat-resistant insulating film, wherein the heat-resistant resin layer comprises not less than two heat-resistant resin layers at least one of which has a coefficient of linear expansion kA (ppm/°C) within the range of $k-10 \leq kA \leq k+20$ (wherein k represents the coefficient of linear expansion of the heat-resistant insulating film). The present invention still further provides a laminate film having a metal layer(s), comprising the above-described heat-resistant resin laminate film according to the present invention, and a metal layer(s) laminated on the heat-resistant resin layer(s). The present invention still further provides a semiconductor device comprising the above-described laminate film having a metal layer(s) according to the present invention. The present invention still further provides a process of producing a laminate film having a metal layer(s) comprising a heat-resistant insulating film and a metal layer(s) laminated on at least one surface of the heat-resistant insulating film through a heat-resistant resin layer(s), the process comprising the steps of laminating at least one heat-resistant resin layer including a heat-resistant resin layer having a coefficient of linear expansion kA (ppm/°C) within the range of $k-10 \leq kA \leq k+20$ (wherein k represents the coefficient of linear expansion of the heat-resistant insulating film) on a copper foil; laminating the resulting metal layer/heat-resistant resin layer laminate (s) and the heat-resistant insulating film which may, as required, have at least one heat-resistant resin layer; and heat pressing the resulting laminate. The present invention still further provides a process of producing a laminate film having a metal layer(s) comprising a heat-resistant insulating film and a metal layer(s) laminated on at least one surface of the heat-resistant insulating film through a heat-resistant resin layer(s), the process comprising the steps of laminating at least one heat-resistant resin layer including a heat-resistant resin layer having a coefficient of linear expansion kA (ppm/°C) within the range of $k-10 \leq kA \leq k+20$ (wherein k represents the coefficient of linear expansion of the heat-resistant insulating film) on the heat-resistant insulating film; laminating the resulting heat-resistant insulating film/heat-resistant resin layer laminate and the metal layer(s) which may, as required, have at least one heat-resistant resin layer; and heat pressing the resulting laminate.

Effects of the Invention

By the present invention, a heat-resistant resin laminate film comprising a heat-resistant insulating film such as a polyimide film and a heat-resistant resin layer laminated thereon, which is free from warping, may be provided. Further, by the present invention, a laminate film with a metal layer(s) comprising a heat-resistant insulating film and a metal foil laminated thereon through a heat-resistant resin layer, which is free from warping when processed into an FPC, that is, when the copper layer is etched, i.e., in the state that the circuit pattern is formed to give an FPC, may be provided. Further, by using the laminate film having a metal layer(s) according to the present invention, a highly reliable semiconductor device may be provided.

Brief Description of the Drawings

Fig. 1 is a schematic view showing an embodiment of the board for printed wiring, according to the present invention.
Fig. 2 is a schematic view showing an embodiment of the board for printed wiring, according to the present invention.
Fig. 3 is a schematic view showing an embodiment of the board for printed wiring, according to the present invention.
Fig. 4 is a schematic view showing an embodiment of a roll laminator which may be used in the present invention.
Fig. 5 is a schematic view showing another embodiment of a roll laminator which may be used in the present invention.

Best Mode for Carrying out the Invention

The heat-resistant resin laminate film according to the present invention comprises a heat-resistant insulating film, and a heat-resistant resin layer(s) laminated on at least one surface of the heat-resistant insulating film, the heat-resistant resin layer having a coefficient of linear expansion kA (ppm/°C) within the range of k-10≤kA≤k+20 (wherein k represents the coefficient of linear expansion of the heat-resistant insulating film). The heat-resistant resin layer may optionally comprise two or more layers. In this case, at least one resin layer has a coefficient of linear expansion kA (ppm/°C) within the range of k-10≤kA≤k+20 (wherein k represents the coefficient of linear expansion of the heat-resistant insulating film). In the present Description, the heat-resistant resin layer having a coefficient of linear expansion kA (ppm/°C) within the range of k-10≤kA≤k+20 (wherein k represents the coefficient of linear expansion of the heat-resistant insulating film) may be referred to as "heat-resistant resin layer A".

By matching the coefficient of linear expansion of the heat-resistant resin layer A with the heat-resistant insulating film such as a polyimide film, the warping of the heat-resistant resin laminate film may be reduced. The coefficient of linear expansion of the heat-resistant resin layer A is not less than k-10, preferably not less than k-7, more preferably not less than k-5, and is not more than k+20, preferably not more than k+15, still more preferably not more than k+10 (wherein k represents the coefficient of linear expansion of the heat-resistant insulating film). If the coefficient of linear expansion is not more than k-10, the heat-resistant resin laminate film warps such that the heat-resistant insulating film is located inner side, and conversely, if the coefficient of linear expansion is more than k+20, the heat-resistant resin laminate film warps such that the heat-resistant resin layer A is located inner side.

When the film is used as a laminate film having a metal layer(s) for the board of FPC, high dimensional stability is demanded. Therefore, as the heat-resistant insulating film, those having a low coefficient of linear expansion are employed, which have a coefficient of linear expansion (k) of 5 to 25 ppm/°C, particularly 10 to 20 ppm/°C. Therefore, in this case, the coefficient of linear expansion kA of the heat-resistant resin layer A is 5 to 30 ppm/°C, preferably 8 to 25 ppm/°C, more preferably 11 to 23 ppm/°C.

Coefficient of linear expansion includes coefficient of thermal expansion, coefficient of humidity expansion and the like. In the present invention, the term "coefficient of linear expansion" means the coefficient of thermal expansion. The coefficient of linear expansion may be measured by a method (TMA method) using a thermo mechanical analysis device. By this method, coefficients of linear expansion in any temperature range such as 30°C to 300°C. 50°C to 200°C or 100°C to 300°C may be measured.

The coefficient of linear expansion in the present invention is an average coefficient of linear expansion from the reference temperature to the measurement temperature, which is calculated according to Equation (1):

$$\text{Average Coefficient of Linear Expansion} = (1/L) \times [(Lt-L0)/(Tt-T0)] \qquad (1)$$

wherein T0 means the reference temperature; Tt represents the preset temperature; L represents the sample length; L0 represents the sample length at the reference temperature; and Lt represents the sample length at the preset temperature.

In the present invention, the reference temperature is the room temperature between 25°C and 35°C, and the coefficients of linear expansion kA (ppm/°C) of the heat-resistant resin layer A within the temperature range from the room temperature to 100°C, or from the room temperature to 200°C, or from the room temperature to 300°C are preferably within the range of k-10≤kA≤k+20 (wherein k represents the coefficient of linear expansion of the heat-resistant insulating film), respectively. Since the film may be subjected to a temperature of about 300°C during the production process of the heat-resistant resin laminate film or the laminate film having a metal layer(s) using the heat-resistant resin laminate film or during the use of the laminate film having a metal layer(s), it is especially preferred that the coefficient of linear expansion kA within the temperature range between room temperature and 300°C be within the above-described range.

Examples of the resin constituting the heat-resistant resin layer A in the present invention include acrylic resins, polyimide resins, polyamide resins, polyamideimide resins, polyetherimide resins, polyether sulfone resins, polysulfone resins and the like. These resins may be used individually, or two or more of these resins may be used in combination. In view of the heat resistance, insulation reliability and adhesion, polyimide resins may preferably be employed.

Polyimide resins are macromolecular resins having imide rings or other cyclic structures, which are derived from their precursors, polyamic acids or esters thereof, by heat or an appropriate catalyst.

The polyimide resins used for constituting the heat-resistant resin layer A comprise as diamine component at least one aromatic diamine represented by any of the Formulae (1) to (3) in an amount of not less than 40 mol%, preferably not less than 50 mol%, still more preferably not less than 60 mol% based on the total diamine component(s). If the content of the above-described aromatic diamine is less than 40 mol%, the coefficient of linear expansion is so large that the heat-resistant resin laminate film and so on warp.

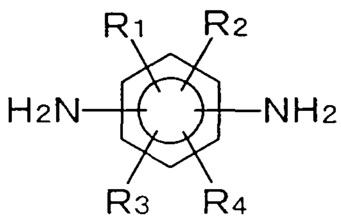
(1)

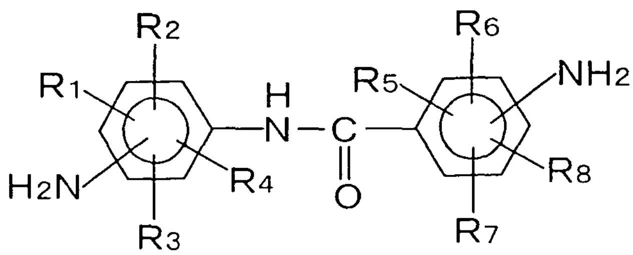
(2)

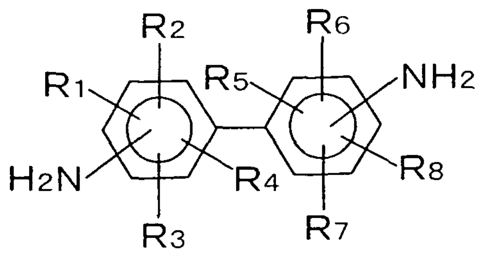
(3)

(wherein $R^1$ to $R^8$, the same or different, are selected from the group consisting of hydrogen, $C_1$-$C_{30}$ alkyl, $C_1$-$C_{30}$ alkoxy, halogen, hydroxy, carboxyl, sulfonic, nitro and cyano).

Specific examples of the above-described aromatic diamine include *p*-phenylenediamine, *m*-phenylenediamine, 2,5-diaminotoluene, 2,4-diaminotoluene, 3.5-diaminobenzoic acid, 2,6-diaminobenzoic acid, 2-methoxy-1,4-phenylenediamine, 2-hydroxy-1,4-phenylenediamine, 2-chloro-1,4-phenylenediamine, 2-nitro-1,4-phenylenediamine, 2-cyano-1,4-phenylenediamine, 2,5-diaminosulfonic acid, 4,4'-diaminobenzanilide, 3,4'-diaminobenzanilide, 3,3'-diaminobenzanilide, 3,3'-dimethyl-4,4'-diaminobenzanilide, 3-methoxy-4,4'-diaminobenzanilide, benzidine, 2,2'-dimethylbenzidine, 3,3'-dimethylbenzidine, 3,3'-dimethoxybenzidine and 3,3'-dichlorobenzidine.

Further, monocyclic aromatic heterocyclic diamines such as 2,4-diaminopyridine and 2,6-diaminopyridine; and polycyclic aromatic diamines such as 1,5-diaminonaphthalene and 2,7-diaminofluorene may also be used. Among the above-described diamines, *p*-phenylenediamine, 4,4'-diaminobenzanilide and 2,2'-dimethylbenzidine are preferred.

In the present invention, by using a siloxane diamine(s) represented by Formula (4) together with the above-described diamine(s), the percentage of water absorption of the obtained polyimide resin may be decreased. However, since the coefficient of linear expansion is sharply increased by adding a siloxane diamine, the amount of the siloxane diamine(s) is 0.1 to 10 mol%, preferably 0.5 to 8 mol%, still more preferably 1 to 6 mol% based on the total diamine components.

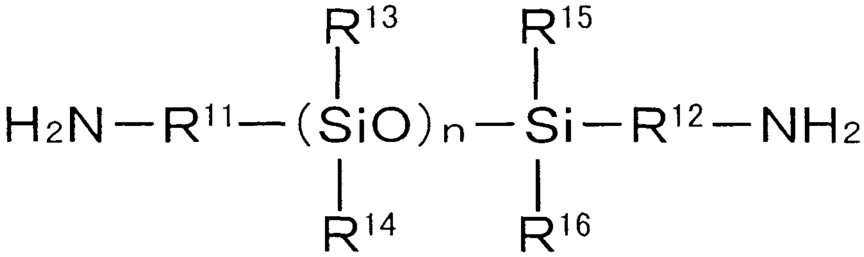

(4)

wherein in Fomula (4), n represents an integer of 1 to 30. $R^{11}$ and $R^{12}$, the same or different, represent a lower alkylene group or phenylene group. R to R , the same or different, represent a lower alkyl group, phenyl group or phenoxy group.

In this case, the percentage of water absorption of the heat-resistant resin layer A is not more than 1.5%, preferably not more than 1.3%, still more preferably not more than 1.2%. If the percentage of water absorption is not less than 1.5%, the film may warp due to humidity expansion, and/or the insulation reliability is reduced.

Since the reactivity of a long chain siloxane diamine represented by Formula (4) is low, it is not preferred to use such a long chain siloxane diamine because the polymerization degree is decreased and heat resistance is deteriorated. In Formula (4), n represents I to 30, preferably 1 to 15, more preferably 1 to 5.

Specific examples of the siloxane diamine represented by Formula (4) include 1,1,3,3-tetramethyl-1,3-bis(4-aminophenyl)disiloxane,1,1,3,3-tetraphenoxy-1,3-bis(4-aminoethyl)disiloxane, 1,1,3,3,5,5-hexamethyl-1,5-bis(4-aminophenyl)trisiloxane, 1,1,3,3-tetraphenyl-1,3-bis(2-aminoethyl)disiloxane, 1,1,3,3-tetraphenyl-1,3-bis(3-aminopropyl) disiloxane, 1,1,5,5-tetraphenyl-3,3-dimethyl-1,5-bis(3-aminopropyl)trisiloxane, 1,1,5,5-tetraphenyl-3,3-dimethoxy-1,5-bis(4-aminobutyl)trisiloxane, 1,1,5,5-tetraphenyl-3,3-dimethoxy-1,5-bis(5-aminopentyl)trisoloxane, 1,1,3,3-tetramethyl-1,3-bis(2-aminoethyl)disiloxane, 1,1,3,3-tetramethyl-1,3-bis(3-aminopropyl)disiloxane, 1,1,3,3-tetramethyl-1,3-bis(4-aminobutyl)disiloxane, 1,3-dimethyl-1,3-dimethoxy-1,3-bis(4-aminobutyl)disiloxane, 1,1,5,5-tetramethyl-3,3-dimethoxy-1,5-bis(2-aminoethyl)trisiloxane, 1,1,5,5-tetramethyl-3,3-dimethoxy-1,5-bis(4-aminobutyl)trisiloxane, 1,1,5,5-tetramethyl-3,3-dimethoxy-1,5-bis(5-aminopentyl)trisiloxane, 1,1,3,3,5,5-hexamethyl-1,5-bis(3-aminopropyl)trisiloxane, 1,1,3, 3,5,5-hexaethyl-1,5-bis(3-aminopropyl)trisiloxane and 1,1,3,3,5,5-hexapropyl-1,5-bis(3-aminopropyl)trisiloxane. These siloxane diamines may be used individually, or two or more of these diamines may be used in combination.

In the present invention, aliphatic diamines, alicyclic diamines containing cyclic hydrocarbon, aromatic diamines other than those described above, and the like may also be used in combination with the above-described diamine(s). Specific examples of such diamines include 1,3-diaminocyclohexane, 1,4-diaminocyctohexane, 4,4'-methylenebis(cyclohexylamine), 3,3'-methylenebis(cyclohexylamine), 4,4'-diamino-3,3'-dimethyldichlorohexylmethane, 4,4'-diamino-3,3'-dimethyldicyclohexyl, *p*-aminobenzylamine, *m*-aminobenzylamine, 4,4'-diaminodiphenyl ether, 3,3'-diaminodiphenyl ether. 3,4'-diaminodiphenyl ether, 4,4'-diaminodiphenyl sulfone, 3,3'-diaminodiphenyl sulfone, 3,3'-diaminodiphenylmethane, 4,4'-diaminodiphenylmethane, 4,4'-diaminodiphenyl sulfide, 3,3'-diaminobenzophenone, 3,4'-diaminobenzophenone, 4,4'-diaminobenzophenone, 3,3'-dimethyl-4,4'-diaminodiphenylmethane, 4,4'-bis(4-aminophenoxy)biphenyl, 2,2-bis[4-(4-aminophenoxy)phenyl]propane, 2,2-bis[4-(3-aminophenoxy)phenyl]propane, bis[4-(4-aminophenoxy)phenyl]methane, bis[4-(3-aminophenoxy)phenyl]methane, bis[4-(4-aminophenoxy)phenyl]ether, bis[4-(3-aminophenoxy) phenyl]ether, bis[4-(4-aminophenoxy)phenyl]sulfone, bis[4-(3-aminophenoxy)phenyl]sulfone, 2,2-bis[4-(4-aminophenoxy)phenyl]hexafluoropropane, 9,9-bis(4-aminophenyl)fluorene and 9,9-bis(3-aminophenyl)fluorene.

The polyimide resin used for the heat-resistant resin layer A contains as tetracarboxylic·acid component(s) one

or more of pyromellitic dianhydride, 3,3',4,4'-biphenyltetracarboxylic dianhydride, 2,3,3',4'-biphenyltetracarboxylic dianhydride, 2,2',3,3'-biphenyltetracarboxylic dianhydride, 3,4,9,10-perylenetetracarboxylic dianhydride, 2,3,6,7-naphthalenetetracarboxylic dianhydride, 1,4,5,8-naphthalenetetracarboxylic dianhydride, 1,2,5,6-naphthalenetetracarboxylic dianhydride, 3,3",4,4"-*p*-terphenyltetracarboxylic dianhydride, 3,3",4,4"-*m*-terphenyltetracarboxylic dianhydride, 2,3,6,7-anthracenetetracarboxylic dianhydride and 1,2,7,8-phenanthlenetetracarboxylic dianhydride, in an amount of not less than 40 mol%, preferably not less than 50 mol%, still more preferably not less than 60 mol% based on the total tetracarboxylic acid component(s). These tetracarboxylic dianhydrides may be used individually or two or more of them may be used in combination. Among the above-described tetracarboxylic acid components, pyromellitic dianhydride and 3,3', 4,4'-biphenyltetracarboxylic dianhydride are especially preferred.

Tetracarboxylic acid components which may be used in combination include alicyclic tetracarboxylic dianhydrides having a cyclic hydrocarbon, and aromatic tetracarboxylic dianhydrides other than those described above. Specific examples thereof include 2,3,5-tricarboxycyclopentylacetic dianhydride, 1,2,3,4-cyclobutanetetracarboxylic dianydride, 1,2,3,4-cyclopehtanetetracarboxylic dianhydride, 1,2,3,5-cyclopentanetetracarboxylic dianhydride, 1,2,4,5-bicylohexenetetracarboxylic dianhydride, 1,2,4,5-cyclohexanetetracarboxylic dianhydride, 1,3,3a,4,5,9b-hexahydro-5-(tetrahydro-2,5-dioxo-3-furanyl)-naphtho[1,2-C]furan-1,3-dione, 3,3',4,4'-benzophenonetetracarboxylic dianhydride, 2,2',3,3'-benzophenonetetracarboxylic dianhydride, 2,3,3',4'-benzophenonetetracarboxylic dianhydride, 3,3',4,4'-diphenyl ether tetracarboxylic dianhydride, 2,3,3',4'-diphenyl ether tetracarboxylic dianhydride, 3,3',4,4'-biphenyltrifluoropropanetetracarboxylic dianhydride, 3,3',4,4'-diphenyl sulfonetetracarboxylic dianhydride and 4,4'-(hexafluoroisopropylidene)diphthalic anhydride.

The molecular weight of the polyimide resin used in the present invention may be controlled by using equimolar amounts of the tetracarboxylic component(s) and the diamine component(s), or by using excess amount of one of these components. Either one of the tetracarboxylic component(s) and the diamine component(s) may be used in excess amount, and an end of polymer chain may be capped by an end cap compound such as an acid component or an amine component. As the end cap compound which is an acid component, dicarboxylic acids and anhydride thereof are preferably employed. As the end cap compound which is an amine component, monoamines are preferably employed. In this case, it is preferred to make the acid equivalent including the end cap compound which is an acid component and the amine equivalent including the end cap compound which is an amine component be identical.

In cases where the molar ratio is adjusted such that one of the tetracarboxylic acid component(s) and diamine component(s) is in excess, a dicarboxylic acid(s) or anhydride thereof or a monoamine(s) thereof, such as benzoic acid, phthalic anhydride, tetrachlorophthalic anhydride and aniline, may be added as an end cap compound(s).

In the present invention, although the molar ratio of the tetracarboxylic acid component(s)/diamine component (s) in the polyimide resin is usually 100/100, in cases where the viscosity of the resin solution is too high, the mole balance of the tetracarboxylic acid component(s)/diamine component(s) may be broken and adjusted within the range from 100/100-95 to 100-95/100 so as to attain the viscosity of the resin solution, which is not problematic in coating the solution. It should be noted, however, that with breaking of the mole balance, the molecular weight of the resin is decreased, so that the strength of the film after curing is decreased and the adhesion with the metal layer and heat-resistant insulating film tends to be deteriorated. Therefore, it is preferred to adjust the molar ratio within the range that the adhesion is not deteriorated.

In the present invention, polyamic acid which is a precursor of the polyimide resin is synthesized by a known method. For example, it may be synthesized by selecting a tetracarboxylic component(s) and a diamine component(s) and reacting them at the above-described molar ratio in a solvent at 0°C to 80°C. In this case, the monoamine(s), dicarboxylic acid(s) and/or anhydride(s) thereof for capping the end of polymer chain may be fed together with the tetracarboxylic dianhydride(s) and the diamine(s), or may be added after the polycondensation reaction between the tetracarboxylic dianhydride(s) and the diamine(s).

Examples of the solvent used in the synthesis of the polyamic acid include amide polar solvents such as *N*-methyl-2-pyrrolidone, *N,N*-dimethylacetamide and *N,N*-dimethylformamide; and lactone polar solvents such as β-propiolactone, γ-butyrotactone, γ-valerolactone, δ-valerolactone, γ-caprolactone and ε-caprolactone; as well as methyl cellosolve, methyl cellosolve acetate, ethyl cellosolve, ethyl cellosolve acetate, methylcarbitol, ethylcarbitol, diethylene glycol dimethyl ether (diglyme) and ethyl lactate. These solvents may be used individually, or two or more of these may be used in combination. The concentration of polyamic acid is usually and preferably 5 to 60% by weight, more preferably 10 to 40% by weight.

In the present invention, to the resin used for the heat-resistant resin layer A, other resin(s) and filler(s) may be added in the range without adversely affecting the effects of the present invention. Examples of the other resins include heat-resistant macromolecular resins such as acrylic resins, acrylonitrile resins, butadiene resins, urethane resins, polyester resins, polyamide resins, polyamideimide resins, polyetherimide resins, epoxy resins, phenol resins, polysulfone resins and polyether sulfone resins. As the filler, organic and inorganic particles and fillers may be employed. Specific examples of the particles and fillers include silica, alumina, titanium oxide, quartz powder, magnesium carbonate, potassium carbonate, barium sulfate, mica and talc. The total content of these heat-resistant macromolecular resins

and fillers is usually not more than 60%, preferably not more than 20%, most preferably 0% based on the weight of the entire heat-resistant resin layer A.

The glass transition temperature of the heat-resistant resin layer A is 250°C to 400°C, preferably 260°C to 380°C, more preferably 280°C to 350°C. Since the coefficient of linear expansion largely changes at temperatures above the glass transition temperature, if the glass transition temperature is not higher than 250°C, the coefficient of linear expansion at room temperature to 300°C is too large. On the other hands, if the glass transition temperature is not lower than 400°C, adhesiveness is poor.

The glass transition temperature of the heat-resistant resin layer A may be measured by various measurement methods. Examples thereof include measurement methods using a differential scanning calorimetry analysis device (DSC method), measurement methods using a thermo mechanical analysis device (TMA method), and dynamic visco-elasticity-measuring methods using a dynamic thermo mechanical analysis device (DMA method). In the DMA method, the maximum value of tan$\delta$ is expressed as the glass transition temperature.

The thickness of the heat-resistant resin layer A is not restricted, and usually 0.2 to 12 $\mu$m, preferably 0.5 to 10 $\mu$m, more preferably 1 to 7 $\mu$m.

As the heat-resistant insulating film used in the present invention, a heat-resistant macromolecule is used. Examples thereof include aromatic polyimide resins, polyphenylene sulfide resins, aromatic polyamide resins, polyamideimide resins and aromatic polyester resins. Specific products include "KAPTON" produced by Du Pont-Toray Co., Ltd., "UPILEX" produced by Ube Industries, Ltd., "APICAL" produced by Kaneka Corporation, "MICTRON" produced by Toray Industries, Inc., and "VECSTAR" produced by Kuraray Co., Ltd. Among these products, aromatic polyimide resins are especially preferably employed. The glass transition temperature of the heat-resistant insulating film is not restricted, and usually not lower than 300°C, preferably not lower than 400°C. Those which do not have a clear glass transition temperature at a temperature of not higher than 500°C are more preferred.

The thickness of the heat-resistant insulating film is not restricted, and is preferably 3 to 150 $\mu$m, more preferably 5 to 75 $\mu$m, still more preferably 10 to 50 $\mu$m. If the thickness is smaller than 3 $\mu$m, the strength thereof as a support may not be sufficient. On the other hand, if the thickness is larger than 150 $\mu$m, the flexibility may be decreased and it may be difficult to fold the film.

One surface or both surfaces of the heat-resistant insulating film used in the present invention may preferably be subjected to an adhesion-improving treatment depending on the object.

Examples of the adhesion-improving treatment include treatments by which irregularities are physically formed in the surface of the film by sand blasting, wet blasting in which a dispersion liquid containing particles such as glass beads in water or the like is blasted to the film at a high speed; treatments by which irregularities are chemically formed in the surface of the film with permanganic acid solution or an alkaline solution; and discharge treatments such as normal pressure plasma treatment, corona discharge treatment and low-temperature plasma treatment. In the present invention, it is preferred to improve the adhesion by a discharge treatment such as normal pressure plasma treatment, corona discharge treatment and low-temperature plasma treatment.

Normal pressure plasma treatment means a treatment in which electric discharging is conducted in an atmosphere such as Ar, $N_2$, He, $CO_2$, CO, air, water vapor or the like. The conditions of the treatment vary depending on the apparatus, the type of the treatment gas, flow rate, the frequency of the electric power source and so on, and the optimum conditions may appropriately be selected.

Low-temperature plasma treatment may be carried out under reduced pressure. The treatment may preferably be carried out by, for example, setting the base film to be treated in a discharge treatment apparatus having a drum-like electrode and a counter electrode comprising a plurality of rod-like electrodes; and applying a DC or AC high voltage across the electrodes in a treatment gas whose pressure has been adjusted to 1 to 1000 Pa, preferably 5 to 100 Pa to carry out discharging, thereby generating plasma of the treatment gas and expose the surface of the base film to the plasma, although the method is not restricted thereto. The conditions of the low-temperature plasma treatment vary depending on the treatment apparatus, type of the treatment gas, pressure, frequency of the electric power source and so on, and the optimum conditions may appropriately be selected. Examples of the treatment gas include Ar, $N_2$, He, $CO_2$, CO, air, water vapor, $O_2$ and $CF_4$. These gases may be used individually or in combination.

Although corona discharge treatment may also be employed, since the effect of promoting the adhesiveness is smaller than the low-temperature plasma treatment, it is preferred to select a heat-resistant resin layer to be laminated, which is easily adhered when the corona discharge treatment is employed.

The heat-resistant resin laminate film according to the present invention is used in a laminate film having a metal layer(s) used as a substrate of FPC (flexible printed circuit board), which laminate film has a metal foil(s) laminated on the side(s) of the heat-resistant resin layer(s). When used as a substrate for FPC, since the film may be subjected to a temperature about 300°C during the step of producing the laminate film having a metal layer(s) by laminating a metal foil(s) with the heat-resistant resin laminate film and/or during the bonding step of an IC chip, the coefficient of linear expansion in the temperature range between room temperature (20°C to 35°C) and 300°C is important.

The metal layer(s) may be formed by lamination of a metal foll(s), vacuum deposition, sputtering, ion plating,

electroless plating, electrolytic plating or the like. These methods may be employed individually or two or more of them may be used in combination. In the present invention, from the viewpoint of productivity and cost, the laminate method in which a metal foil(s) is(are) laminated on the side(s) of the heat-resistant resin layer of the heat-resistant resin laminate film, and heat pressing the resulting laminate film to form the metal layer(s) is most preferred.

The metal layer used in the present invention is made of a metal foil such as copper foil, aluminum foil, SUS foil or the like, and copper foil is usually employed. Copper foil includes electrodeposited copper foil and roll annealed copper foil, and either of these foils may be employed.

To promote the adhesiveness with the resin or the like, the side of the metal foil such as copper foil, which contacts the resin or the like, may be subjected to a surface roughening treatment. The surfaces of a copper foil are usually called S face and M face, respectively. When a resin is adhered to the foil, it is usually adhered to the M face. Therefore, the surface roughening treatment is usually performed on the M face. In cases where a resin or the like is adhered to both surfaces of the copper foil, both of the S face and M face may be subjected to the surface roughening treatment. The surface roughening treatment may be, for example, in case of copper foil, the step of depositing fine particles of copper with a size of 1 to 5 μm by electrodeposition or the like on one or both surfaces of the raw foil formed by electrolytic plating, thereby forming irregularities on the surface(s).

Due to the miniaturization of the circuit pattern of FPC, it is preferred that the irregularities of not only the S face, but also the M face of the copper foil be as small as possible, and a copper foil of which both surfaces are not subjected to the surface roughening treatment and are smooth is preferred. The Ra (centerline average roughness) of the S face of the copper foil is not more than 0.5 μm, preferably not more than 0.4 μm, and Rz (ten points average roughness) is not more than 2.0 μm, preferably not more than 1.8 μm. The Ra of the M face is not more than 0.7 μm, preferably not more than 0.5 μm, still more preferably not more than 0.4 μm, and Rz is not more than 3.0 μm, preferably not more than 2.0 μm, still more preferably not more than 1.8 μm.

The thickness of the copper foil is I μm to 150 μm, and may be appropriately selected depending on the use. Due to the miniaturization of the circuit pattern of FPC, it is preferred that the thickness of the copper foil be as small as possible. However, if the copper foil is too thin, it is difficult to handle the copper foil as it is. The copper foil with a thickness of 3 μm or 5 μm is handled in the form of copper foil with carrier, in which the copper foil is attached to a carrier made of a resin or metal foil having a thickness of about 20 μm to 50 μm, and the carrier is peeled off after heat pressing the copper foil with the resin or the like. In the present invention, the thickness of the copper foil is not more than 20 μm, preferably not more than 15 μm, still more preferably not more than 10 μm, and not less than 1 μm, preferably not less than 3 μm, still more preferably not less than 5 μm.

The surface(s) of the copper foil may be subjected to rustproofing. The rustproofing may be usually carried out by laminating a thin layer of nickel, zinc or chromium compound on the surface(s) of the copper foil. Further, to improve the adhesion with resin or the like, the surface(s) of the copper foil may be subjected to a silane coupling treatment.

The laminate film having a metal layer(s) according to the present invention may have various constitutions including, not only those having the metal layer on one surface and having the metal layers on both surfaces, but also those having various layer constitutions of the heat-resistant resin layer(s). Various production processes may be employed depending on the constitutions.

In the present invention, the evaluation of warping is performed on the heat-resistant resin laminate film obtained by laminating a metal foil such as a copper foil, and etching the entire formed metal layer. The warping may also be measured on the film obtained by laminating a heat-resistant resin layer on a heat-resistant insulating film and performing an appropriate heat treatment or the like. When a heat treatment or the like is performed in the preparation of the sample, the measurement may preferably be carried out after leaving the sample to stand at room temperature of 20°C to 30°C, and at a humidity of 50% to 60% RH for not less than 24 hours. The sample may be cut into an optional size such as 50 mm x 50 mm square. The warping was measured by placing the cut sample on a flat plate, and measuring the heights of the 4 corners. The average of the measured heights was used as the value of the warping.

In cases where the sample is 50 mm x 50 mm square, when the height of warping is not less than 20 mm, since the sample is rolled into cylindrical form, the height of warping cannot be measured accurately. The height of warping is not more than 4 mm, preferably not more than 3 mm, still more preferably not more than 1 mm.

A first mode of the laminate film having a metal layer(s) according to the present invention is shown in Fig. 1. Fig. 1(a) shows the mode of the laminate film having a metal layer on one side, and Fig. 1(b) shows the mode of the laminate film having metal layers on both sides. The laminate film comprises a heat-resistant insulating film 2, a heat-resistant resin layer(s) 3 and a metal foil(s) 1. Such a laminate film may be produced by, for example, the following method. The heat-resistant resin layer(s) 3 having a coefficient of linear expansion kA (ppm/°C) within the range of $k-10<kA<k+20$ (wherein k represents the coefficient of linear expansion of the heat-resistant insulating film) is(are) formed on the heat-resistant insulating film 2 or on the metal foil(s) 1. Then the obtained heat-resistant insulating film/heat-resistant resin layer laminate is laminated with the metal foil(s) such that the metal foil faces the heat-resistant resin layer, and the resulting laminate is heat pressed. Alternatively, the metal foil/heat-resistant resin layer laminate(s) is(are) laminated with the heat-resistant insulating film such that the heat-resistant insulating film faces the heat-resistant resin

layer, and heat pressing the resulting laminate, thereby obtaining a laminate film having a metal layer(s).

In the production process of the laminate film having a metal layer(s) shown in Fig. 1, since the laminate is heat pressed, which laminate is obtained by laminating the intermediate laminate having the heat-resistant resin layer (s) 3 formed on the heat-resistant insulating film with the metal foil(s) 1, or which laminate is obtained by laminating the intermediate laminate(s) having the heat-resistant resin layer 3 on the metal foil(s) I, such that the heat-resistant resin layer(s) 3 and the heat-resistant insulating film 2 face each other, a high temperature of not lower than 300°C, preferably not lower than 350°C, more preferably not lower than 380°C is necessary when conducting the heat press. Even if the heat press is performed at such a high temperature, the adhesion force after adhesion is relatively small.

A second mode of the laminate film having a metal layer(s) according to the present invention is shown in Fig. 2. Fig. 2(a) shows the mode of the laminate film having a metal layer on one side, and Fig. 2(b) shows the mode of the laminate film having metal layers on both sides. In this mode, the heat-resistant resin layer has a multilayer constitution comprising not less than 2 layers, and at least one of the layers is the heat-resistant resin layer A having a coefficient of linear expansion kA (ppm/°C) within the range of $k-10 \leq kA \leq k+20$ (wherein k represents the coefficient of linear expansion of the heat-resistant insulating film). The mode in which the layers are laminated such that the heat-resistant resin layer A contacts the metal layer is the best mode with which the warping after etching of the metal layer(s) hardly occurs. A heat-resistant resin layer having a different composition and different physical properties from those of the heat-resistant resin layer A may be provided, which has a film thickness within the range not causing warp, for the purpose of improving the adhesiveness or the like. The heat-resistant resin layer provided between the metal layer and the heat-resistant resin layer A has a thickness of 0.001 to 5 μm, preferably 0.01 to 3 μm, still more preferably 0.1 to 2 μm. As the resin constituting this heat-resistant resin layer, the resins which may be employed for constituting the heat-resistant resin layer B described below may be employed.

The laminate film having a metal layer(s) shown in Fig. 2 may be produced by, for example, the following process. On a heat-resistant insulating film 2 or a metal foil(s) 1, a multilayer heat-resistant resin layer(s) 4 containing at least one layer of the heat-resistant resin layer A 3 is(are) laminated. The obtained heat-resistant insulating film 2/heat-resistant resin layer 4 laminate is then laminated with a metal foil(s) I such that the metal foil(s) 1 faces the heat-resistant resin layer 4. The resulting laminate is heat pressed. Alternatively, the metal foil 1/heat-resistant resin layer 4 laminate (s) is(are) laminated with the heat-resistant insulating film 2 such that the heat-resistant insulating film faces the heat-resistant resin layer. The resulting laminate is heat pressed, thereby obtaining the laminate film having a metal layer(s). Alternatively, on the heat-resistant insulating film 2 and on the metal foil(s) 1, at least one heat-resistant resin layer is formed, and the obtained heat-resistant insulating film/heat-resistant resin layer laminate and the metal foil/heat-resistant resin layer laminate are laminated such that the heat-resistant resin layers of the respective laminates face each other. The resulting laminate is heat pressed, thereby obtaining the laminate film having a metal layer(s). In this case, the heat-resistant resin layer A is preferably laminated on the side of the metal foil.

A third mode of the laminate film having a metal layer(s) according to the present invention is shown in Fig. 3. Fig. 3(a) shows the mode of the laminate film having a metal layer on one side, and Fig. 3(b) shows the mode of the laminate film having metal layers on both sides. The especially preferred mode of the laminate film having a metal layer (s) shown in Fig. 2 is shown in Fig. 3. That is, the mode wherein the heat-resistant resin layer(s) A having a coefficient of linear expansion kA (ppm/°C) within the range of $k-10 \leq kA \leq k+20$ (wherein k represents the coefficient of linear expansion of the heat-resistant insulating film) is(are) laminated on the side of the metal layer(s), and a heat-resistant resin layer (s) (hereinafter referred to as "heat-resistant resin layer B") having a glass transition temperature lower than that of the heat-resistant resin layer A is(are) laminated on the side of the heat-resistant insulating film.

The laminate film having a metal layer(s) according to the third mode may be produced by the similar method to that of the laminate film having a metal layer(s) according to the second mode. An especially preferred production process is one comprising the steps of laminating the heat-resistant resin layer(s) A 3 on the metal foil(s) 1, and laminating a heat-resistant resin layer(s) B 5 on the heat-resistant insulating film 2, thereby forming a metal foil/heat-resistant resin layer A 3 laminate(s) and a heat-resistant insulating film 2/heat-resistant resin layer(s) B 5 laminate, respectively; laminating the thus obtained laminates such that the heat-resistant resin layer(s) A 3 and the heat-resistant resin layer(s) B 5 face each other; and heat pressing the resulting laminate, thereby obtaining the laminate film having a metal layer (s). The thus obtained laminate film having a metal layer(s) is free from warping after the etching of the metal layer(s), and the adhesion force is large. Further, the heat press may be attained at a relatively low temperature, which is advantageous in production.

The coefficient of linear expansion of the heat-resistant resin layer B (one or more heat-resistant resin layers other than the heat-resistant resin layer A having a coefficient of linear expansion within the above-described range) does not need to be within the above-described range of the coefficient of linear expansion of the heat-resistant resin layer A, and is usually about 30 ppm/°C to 500 ppm/°C, preferably 40 ppm/°C to 200 ppm/°C. The present inventors first discovered that if there is at least one heat-resistant resin layer A, the warping of the laminate film and the laminate film having a metal layer(s) may be reduced into the satisfactory range, even if at least one heat-resistant resin layer B having a larger coefficient of linear expansion exists. Therefore, a resin(s) having better adhesiveness may be employed

for constituting the heat-resistant resin layer B, thereby the adhesion of the laminate film and the laminate film having a metal layer(s) may be further promoted.

As the heat-resistant resin layer B used in the present invention, thermoplastic resins and/or thermosetting resins may be employed. Examples of the resins include acrylic resins, acrylonitrile resins, butadiene resins, urethane resins, polyester resins, epoxy resins, phenol resins, polyimide resins, polyamide resins, polyamideimide resins, polyetherimide resins, polyether sulfone resins and polysulfone resins. These resins may be used individually, or two or more of these resins may be used in combination. From the viewpoint of heat-resistance, insulation reliability and adhesiveness, polyimide resins, epoxy resins, phenol resins and polyamide resins are preferred. To these resins, organic or inorganic particles and fillers may be added. Specific examples of the particles and fillers include silica, alumina, titanium oxide, quartz powder, magnesium carbonate, potassium carbonate, barium sulfate, mica and talc.

In cases where the heat-resistant resin layer B is a polyimide resin, the glass transition temperature of the heat-resistant resin layer B is 120°C to 280°C, preferably 150°C to 250°C, more preferably 170°C to 220°C. If the glass transition temperature is lower than 120°C, adhesion force is large but the heat-humidity resistance is poor, and if it is higher than 280°C, the adhesiveness is poor.

As the polyimide resin used for the heat-resistant resin layer B in the present invention, those containing various diamines and tetracarboxylic dianhydrides may be employed as long as the glass transition temperature is within the above-described range. As the diamine component(s), the siloxane diamines represented by Formula (4) are preferred because the glass transition temperature of the polyimide resin to be obtained may be easily controlled, the percentage of water absorption may be made low, and the adhesion force is large. The amount thereof is 5 to 95 mol%, preferably 10 to 80 mol%, more preferably 15 to 60 mol% based on the total diamine components.

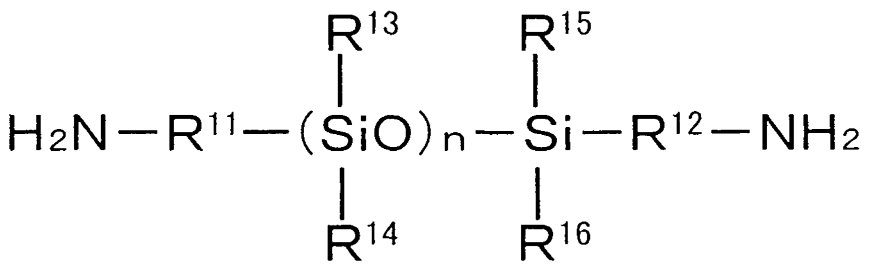 (4)

wherein in Formula (4), n represents an integer of 1 to 30. $R^{11}$ and $R^{12}$ the same or different, represent a lower alkylene group or phenylene group. $R^{13}$ to $R^{16}$, the same or different, represent a lower alkyl group, phenyl group or phenoxy group.

In cases where the heat-resistant resin layer B is a thermosetting resin containing an epoxy compound, the glass transition temperature of the heat-resistant resin layer B is 50°C to 250°C, preferably 80°C to 220°C, still more preferably 100°C to 200°C. If glass transition temperature is lower than 50°C, the heat-resistance and heat-humidity resistance are degraded, and if it is higher than 200°C, the adhesiveness is poor.

Examples of the thermosetting resins include epoxy compounds, cyanate compounds, benzoxazole compounds, bismaleimide compounds and resins made of unsaturated compounds such as those having an acetylene group. In the present invention, resins made of epoxy compounds are preferred.

Examples of the epoxy compounds which may be used as the heat-resistant resin layer B include phenolic novolak type epoxy compounds, cresol novolak type epoxy compounds, bisphenol A type epoxy compounds, bisphenol F type epoxy compounds, bisphenol S type epoxy compounds; epoxy compounds of aralkyl resins obtained by xylylene bonding of thiodiphenols, phenols or naphthols; epoxy compounds of phenol-dichloropentadiene resins; cycloaliphatic epoxy compounds; heterocyclic epoxy compounds, glycidyl ester type epoxy compounds obtained by reactions of a polybasic acid such as phthalic acid or dimer acid with epichlorohydrin; glycidyl amine type epoxy compounds obtained by the reactions of a polyamine such as diaminodiphenylmethane, diaminodiphenyl sulfone or isocyanuric acid with epichlorohydrin; brominated epoxy compounds; and epoxy compounds having cyclohexene oxide such as ε-caprolactone-modified 3,4-epoxycyclohexylmethyl-3',4'-epoxycyclohexane carboxylate, trimethylcaprolactam-modified 3,4-epoxycyclohexylmethyl-3',4'-epoxycyclohexane carboxylate, β-methyl-δ-valerolactone-modified 4-epoxycyclohexylmethyl-3',4'-epoxycyclohexane carboxylate. Further, silicone-modified epoxy compounds obtained by reacting an organopolysiloxane or the above-described epoxy compounds having a glycidyl group with a carboxyl group-containing organosiloxane may also be used, but the epoxy compounds which may be used in the present invention are not restricted thereto. Further, at least one of these epoxy compounds and silicone-modified epoxy compounds may be used in combination.

The curing agent of the above-described epoxy compounds is not restricted, and examples thereof include

polyamines such as diethylenetriamine, triethylenetriamine, methaxylenediamine and diaminodiphenylmethane; polyamides such as dimer acid polyamide; acid anhydrides such as phthalic anhydride, tetrahydromethylphthalic anhydride, hexahydrophthalic anhydride, trimellitic anhydride and methylnadic anhydride; 3-aminophenol, resorcinol, catechol, hydroquinone, pyrogallol, 3-hydroxybenzoic acid, 3-cyanophenol, 2,3-diaminophenol, 2-amino-3-hydroxybenzoic acid, 3-hydroxyphenylacetamide, 3-hydroxyisophthalic acid, 3-hydroxyphenyl acetic acid, 3-phenolsulfonic acid; phenol resins such as phenolic novolak, phenolaralkyl, bisphenol A and bisphenol F; resol type phenol resins, polymercaptane; tertiary amines such as 2-ethyl-4-methylimidazole and tris(dimethylaminomethyl)phenol; and Lewis acid complexes such as trifluoroboron-ethylamine complex. Among these, phenol resins are preferred.

In the heat-resistant resin layer B, a thermoplastic resin(s) which is(are) plastic within the temperature range between 80°C and 200°C may be added. Examples of such resins include polyolefins such as polyethylene, polypropylene and ethylene copolymer resins; styrene resins such as polystyrene and ABS resin; polyvinyl chloride, polyvinylidene chloride, polyethylene terephthalate, polyethylene naphthalate, polybutylene terephthalate, polyallylate resins, polyoxybenzoyl, polycarbonate, polyacetal and polyphenylene ether. Among these, in view of the degradation at high temperatures and good electrical characteristics, polyamide resins are preferably used. Various known polyamide resins may be used. Especially, those containing dicarboxylic acid (the so called dimer acid) having 36 carbon atoms, which has a low percentage of water absorption, as an indispensable component, are preferred. The polyamide resins containing dimer acid may be obtained by the conventional polycondensation between dimer acid and a diamine. In this case, a dicarboxylic acid(s) other than dimer acid, such as adipic acid, azelaic acid or sebacic acid may be contained as a copolymerizable component(s). As the diamine, a known diamine such as ethylene diamine, hexamethylenediamine or piperazine may be used. In view of hygroscopicity and solubility, two or more of these diamines may be used in combination. The content of such a thermoplastic resin(s) is not restricted, and is usually not more than 70%, preferably not more than 20%.

To the thermosetting resin constituting the heat-resistant resin layer B, a curing accelerator(s) may be added. As the curing accelerator, known curing accelerators including aromatic polyamines, amine complexes of trifluoroboron such as trifluoroboron-triethylamine complex; imidazole derivatives such as 2-alkyl-4-methylimidazole and 2-phenyl-4-alkylimidazole; organic acids such as phthalic anhydride and trimellitic anhydride; dicyandiamide; and triphenylphosphine. The content of the curing accelerator(s) is not restricted, and is usually not more than 5%, preferably not more than 1% based on the weight of the heat-resistant resin layer B.

Examples of the solvent which is used for solving and mixing the above-described compounds include methyl cellosolve, butyl cellosolve, methyl ethyl ketone, dioxane, acetone, cyclohexanone, cyclopentanone, isobutyl alcohol, isopropyl alcohol, tetrahydrofuran, dimethyl sulfoxide, γ-butyrolactone, toluene, xylene, chlorobenzene, benzyl alcohol, isophorone, methoxymethyl butanol, ethyl lactate, propylene glycol monomethyl ether and its acetate, and *N*-methyl-2-pyrrolidone, as well as solvents containing at one or more of these solvents.

The thickness of the heat-resistant resin layer A (in cases where a plurality of heat-resistant resin layers A exist, the total thickness thereof) is not less than twice, preferably not less than 2.5 times, still more preferably not less than 3 times the thickness of the heat-resistant resin layer B (in cases where a plurality of heat-resistant resin layers B exist, the total thickness thereof). If the thickness of the heat-resistant resin layer A is not more than twice the thickness of the heat-resistant resin layer B, the warping after the etching of the metal layer may be large.

In the present invention, the heat press may be carried out using a heat press, heated roll laminator or the like. Since the heated roll laminator can continuously carry out heat press on long films and metal foils, it may preferably be used from the viewpoint of productivity. The heat press using the heated roll laminator is carried out by passing a metal foil(s) 8 and a film 9 having a laminated heat-resistant resin layer(s) through at least one pair of heated rolls 6 and 7, as shown in Fig. 4. Here, Fig. 4(a) and Fig. 4(b) show the method of heat press of a laminate film having a metal layer on one side, and the method of heat press of a laminate film having metal layers on both sides, respectively, using the heated roll laminator. In Fig. 4 (and in Fig. 5 described below), reference numeral 10 denotes a take-up roll.

The rolls of the heated roll laminator may be various combinations of rolls such as metal roll-metal roll, metal roll-rubber roll, rubber roll-rubber roll and the like. Usually, when producing a laminate film having a metal layer on one side, the combination of metal roll-rubber roll is employed. In this case, the heat press is carried out such that the copper foil contacts the metal roll, and the heat-resistant insulating film contacts the rubber roll. It should be noted, however, that in cases where the roll temperature is not lower than 200°C, the combination of metal roll-metal roll is preferred. When producing a laminate film having metal layers on both sides, the combination of metal roll-metal roll is employed.

The conditions of the heated roll laminator, such as the roll temperature, roll nip pressure, feed rate and the like may be appropriately selected depending on the type, composition and production process of the heat-resistant resin layer used. In general, the roll temperature is set in the range between 50°C and 500°C, preferably between 100°C and 450°C. Although a laminator in which only one of the rollers can be heated may be used, a laminator in which both rollers can be heated is preferred. A laminator in which both rollers can be heated and temperature control of the both rollers can be attained independently is more preferred. The roll nip pressure of the heated roll laminator is usually set in the range between 0.5 to 200 N/mm, preferably 2 to 150 N/mm in terms of line pressure. The feed rate is usually set

in the range between 0.1 and 50 m/min, preferably 0.4 to 30 m/min.

In cases where the lamination is carried out at a roll temperature of not lower than 300°C, the lamination may be carried out in nitrogen atmosphere or in vacuum in order to prevent oxidation of the metal foil(s). Further, as shown in Fig. 5, the heat press may be carried out such that heat-resistant resin films such as a polyimide films or metal foils such as SUS or aluminum as protective films I 1 are interposed between the surface of the heated roll and the metal foil 8, and between the surface of the heated roll and the film 9 on which the heat-resistant resin layer(s) is(are) laminated, respectively. Here, Fig. 5(a) and Fig. 5(b) show the method of heat press of a laminate film having a metal layer on one side, and the method of heat press of a laminate film having metal layers on both sides, respectively, using the heated roll laminator. In Fig. 5, reference numeral I 1 denotes a supply roll of the protective film and reference numeral 12 denotes a take-up roll of the protective film.

A process of producing the laminate film having a metal layer(s) shown in Fig. I will now be described by way of a concrete example.

A solution of polyamic acid which is a precursor of the polyimide resin having a coefficient of linear expansion kA (ppm/°C) within the range of $k-10 \leq kA \leq k+20$ (wherein k represents the coefficient of linear expansion of the heat-resistant insulating film) is coated on at least one surface of the heat-resistant insulating film (e.g., a polyimide film) to a thickness after curing of 0.2 to 12 μm, preferably 0.5 to 10 μm, more preferably 1 to 7 μm. The coating method includes those using a bar coater, roll coater, knife coater, comma coater, reverse coater, doctor blade float coater and gravure coater.

The solvent of the solution coated on the polyimide film is removed under heat at about 60°C to 200°C continuously or intermittently for 1 to 60 minutes. The resulting film is then heat-treated at 200°C to 400°C, preferably 240°C to 350°C, more preferably 260°C to 320°C for 1 to 48 hours so as to convert the polyamic acid resin in the heat-resistant resin layer(s) to polyimide resin, thereby forming a laminate of the polyimide film/heat-resistant resin layer made of polyimide resin. In the present invention, the heat treatment may be carried out such that the temperature is raised stepwise to the target temperature within the range described above.

A copper foil(s) is(are) laminated on the obtained polyimide film/heat-resistant resin layer(s) such that the heat-resistant resin layer(s) and the copper foil(s) face each other, and the resulting laminate is heat pressed with the heated roll laminator. The heat press by the heated roll laminator is carried out such that polyimide films having a thickness of 20 to 500 μm, preferably 30 to 200 μm are used as the protective films, and the laminate of the copper foil(s) and the polyimide film/heat-resistant resin layer(s) A is sandwiched between the protective films as shown in Fig. 5 (as shown in Fig. 5(a) in case of a laminate film having a metal layer on one side and as shown in Fig. 5(b) in case of a laminate film having metal layers on both sides). The temperature of the heated rolls is, in case of the structure shown in Fig. 1, for example, 300°C to 500°C, preferably 350°C to 450°C, still more preferably 380°C to 420°C. The roll nip pressure is 2 to 150 N/mm, preferably 5 to 100 N/mm, more preferably 10 to 80 N/mm in terms of line pressure.

In the present invention, the obtained laminate film having a copper layer(s) may be further heat-treated. This heat treatment may be carried out by a batch treatment wherein the laminate film having a copper layer(s) is rolled; by a continuous treatment using roll-to-roll processing; or by a sheet-fed treatment using the cut sheet of the laminate. The heat treatment is carried out at 200°C to 400°C, preferably 240°C to 350°C, still more preferably 260°C to 320°C for I to 48 hours. The heat treatment may be carried out such that the temperature is raised stepwise to the target temperature. In order to prevent oxidation of the copper layer(s), it is preferred to carry out the treatment in vacuum or under nitrogen atmosphere.

A process of producing the laminate film having a metal layer(s) shown in Fig. 3 will now be described by way of a concrete example.

The solution is applied as described above, and the solvent of the applied solution is removed under heat, thereby drying the film. Then the resulting film is heat-treated to convert the polyamic acid resin in the heat-resistant resin layer(s) to polyimide resin, and the laminate of the copper foil(s)/heat-resistant resin layer made of polyimide resin is formed. The conditions are the same as in the production process described above. In this case, the temperature may be raised stepwise to the target temperature in the range described above. Further, in order to prevent oxidation of the copper foil, it is preferred to carry out the heat treatment in vacuum or under nitrogen atmosphere.

Then a solution of the polyamic acid resin which is a precursor of the polyimide resin having a glass transition temperature lower than that of the heat-resistant resin layer A is coated on at least one surface of a polyimide film to a thickness after curing of 0.01 to 5 μm, preferably 0.1 to 4 μm, more preferably 0.5 to 3 μm. After drying, the resulting film was heat-treated to form a laminate of the heat-resistant resin layer(s) B comprising polyimide film/polyimide resin. The method of coating, drying and heat treatment are the same as described above.

The laminates are then laminated such that the heat-resistant resin layer A faces the heat-resistant resin layer B, and the resulting laminate is heat pressed, thereby a laminate film having a copper layer(s) is obtained. In the heat press by the heated roll laminate, the temperature of the heated rolls is, in case of the structure shown in Fig. 3, for example, 200°C to 400°C, preferably 250°C to 380°C, still more preferably 280°C to 350°C. The roll nip pressure is 2 to 100 N/mm, preferably 5 to 80 N/mm, more preferably 10 to 60 N/mm in terms of line pressure.

In cases where the temperature of the heated rolls is not higher than 300°C, it is not necessary to use protective films as shown in Fig. 5 in the heat press, and the heat press may be carried out by the method as shown in Fig. 4. After the heat press, the obtained laminate film having a copper layer(s) may be further heat-treated, and the heat treatment may be carried out as described above.

In the above-described production process, the production process is preferred, in which the heat-resistant resin layer(s) A and the heat-resistant resin layer(s) B are not converted to polyimide resins, but the laminates are laminated in the state such that the polyamic acid resins remained in the form of the polyamic acid resins; the resulting laminate is heat pressed, and then the obtained laminate film having a copper layer(s) is heat-treated to convert the polyamic acid resins constituting the heat-resistant resin layer(s) A and heat-resistant resin layer(s) B to polyimide resins.

With this production process, since the heat press is carried out in the state that the polyamic acids remain as they are, the temperature during the heat press may be further lowered. Thus, the temperature of the heated rolls in the heated roll laminator is 100°C to 260°C, preferably 140°C to 240°C, still more preferably 160°C to 220°C.

By forming a circuit pattern(s) in the metal layer(s) of the laminate film having a metal layer(s) according to the present invention, a flexible printed circuit board (FPC) may be produced. The pitch in the circuit pattern is not restricted, and is preferably 10 to 150 μm, more preferably 15 to 100 μm, still more preferably 20 to 80 μm.

As an example of the method for producing a semiconductor device by mounting a semiconductor chip (IC), an example of producing a semiconductor device using COF utilizing the flip chip technology will now be described.

The laminate film having a metal layer(s) according to the present invention is slit into a desired width. Then a photoresist layer is coated on the metal layer, and a circuit pattern is formed by exposure through a mask. The metal layer was then subjected to wet etching, and the remaining photoresist layer was removed to form a metal circuit pattern. On the metal circuit pattern thus formed, tin or gold is plated to a thickness of 0.2 to 0.8 μm, and a solder resist is coated on the circuit pattern, thereby a COF tape is obtained.

By bonding an IC having gold bumps to the inner lead of the COF tape obtained by the method described above by flip chip mounting and sealing the resultant with a resin, a semiconductor device according to the present invention may be obtained.

The method for mounting the IC includes metal-bonding method in which the wiring and the bumps of IC are subjected to gang bonding; wire bonding method in which the bonding section of IC and the inner lead of the COF tape are bonded by wire bond; ACF method in which in which the bonding is carried out by using an adhesive film containing an conductive filler in an adhesive layer; and NCP method in which the bonding is carried out using a non-conductive adhesive. Although the bonding may be carried out at a relatively low temperature by the ACF method and NCP method, metal bonding methods, especially Au-Sn eutectic bonding is widely used in general from the viewpoint of reliability of the bonding.

In the Au-Sn eutectic bonding, to absorb the distribution in the height of the bumps of the IC and the wirings, a load of 20 to 30 g is applied per bump. In order that the gold and tin form an eutectic so as to attain a reliable bonding, a temperature of not lower than 280°C is required. Therefore, the temperature of the surfaces to be bonded is usually set to a temperature between 300°C and 400°C.

Examples

The present invention will now be described by way of Examples thereof. However, the present invention is not restricted to these Examples. Methods for measuring warp, glass transition temperature and percentage of water absorption are now described.

(1) Evaluation of Warping
After laminating a copper foil, the entire copper layer was etched with ferric chloride solution. After cutting the sample to a size of 50 mm x 50 mm, the sample was left to stand at 25°C at 50% RH for 24 hours, and then laid on a flat plate. The heights of the 4 corners were measured, and the average of the measured heights was defined as the value of the warping.

(2) Measurement of Adhesion Force (normal state)
The laminate film having a copper layer was etched with ferric chloride solution to a width of 2 mm, and the resulting metal layer having a width of 2 mm was peeled off at a pulling rate of 50 mm/min in the direction of 90° with "TENSILON" UTM-4-100 produced by TOYO BOLDWIN.

(3) Measurement of Coefficient of Linear Expansion
After applying a resin solution with a bar coater to a prescribed thickness on a glossy surface of an electrodeposited copper foil having a thickness of 18 μm, the resultant was dried at 80°C for 10 minutes, and then at 150°C for 10 minutes, and was further heat-treated under nitrogen atmosphere at 280°C for 1 hour to thermally cure the resin. Then the entire of the electrodeposited copper foil was etched with ferric chloride solution to obtain a monolayer film of the heat-resistant resin layer.

The thus obtained monolayer film was cut into a shape having a prescribed width, and the resultant film was made into cylindrical shape, followed by measuring the sample length in the temperature range from 30°C to 300°C at a rate of raising temperature of 5°C/min using a thermo mechanical analysis device SS-61 00 (produced by Seiko Instruments Inc). The average coefficient of linear expansion in the range of 30°C to 300°C was calculated from the measurement results according to Calculation Formula (2):

$$\text{Average Coefficient of Linear Expansion} = (1/L30)\times[(L300-L30)/(300-30)] \quad (2)$$

wherein L30 represents the sample length at 30°C, and L300 represents the sample length at 300°C.
(4) Measurement of Glass Transition Temperature
After applying a solution of polyamic acid resin (PA1-8) with a bar coater to a prescribed thickness on a glossy surface of an electrodeposited copper foil having a thickness of 18 μm, the resultant was dried at 80°C for 10 minutes, and then at 150°C for 10 minutes, and was further heat-treated under nitrogen atmosphere at 280°C for I hour to thermally cure the resin. Then the entire of the electrodeposited copper foil was etched with ferric chloride solution to obtain a monolayer film of the heat-resistant resin layer.
After applying a solution of a polyamide/epoxy/phenol heat-resistant resin (EP1) with a bar coater to a prescribed thickness on a glossy surface of an electrodeposited copper foil having a thickness of 18 μm, the resultant was dried at 80°C for 10 minutes, and then at 120°C for 10 minutes, and was further heat-treated at 160°C for 1 hour to thermally cure the resin. Then the entire of the electrodeposited copper foil was etched with ferric chloride solution to obtain a monolayer film of the heat-resistant resin layer.
About 10 mg of the thus obtained the monolayer film of the heat-resistant resin was packed in a standard vessel made of aluminum, and was subjected to measurement (DSC method) using a differential scanning calorimeter DSC-50 (produced by Shimadzu Corporation). Glass transition temperature was calculated from the point of inflection in the obtained DSC curve. After preliminary drying the sample at 80°C for 1 hour, the measurement was carried out at a rate of temperature rise of 20°C/min.
(5) Measurement of Percentage of Water Absorption
After applying a solution of polyamic acid resin (PA1-8) with a bar coater to a prescribed thickness on a glossy surface of an electrodeposited copper foil having a thickness of 18 μm, the resultant was dried at 80°C for 10 minutes, and then at 150°C for 10 minutes, and was further heat-treated under nitrogen atmosphere at 280°C for I hour to thermally cure the resin. Then the entire of the electrodeposited copper foil was etched with ferric chloride solution to obtain a monolayer film of the heat-resistant resin layer.

After applying a solution of a polyamide/epoxy/phenol heat-resistant resin (EP1) with a bar coater to a prescribed thickness on a glossy surface of an electrodeposited copper foil having a thickness of 18 μm, the resultant was dried at 80°C for 10 minutes, and then at 120°C for 10 minutes, and was further heat-treated at 160°C for 1 hour to thermally cure the resin. Then the entire of the electrodeposited copper foil was etched with ferric chloride solution to obtain a monolayer film of the heat-resistant resin layer.
About 200 mg of the thus obtained the monolayer film of the heat-resistant resin was immersed in water at 30°C for 24 hours, and the film was then dried at 80°C for 3 hours. The weight after immersion in water and the weight after drying were respectively measured, and the difference therebetween was divided by the weight after drying to calculate the percentage of water absorption.
The abbreviations of the acid dianhydrides and diamines used in the Production Examples below mean the following:

BPDA: 3,3',4,4'-biphenyltetracarboxylic dianhydride
OPDA: 3,3',4,4'-diphenylether tetracarboxylic dianhydride
PMDA: pyromellitic dianhydride
SiDA: 1,1,3,3-tetramethyl-1,3-bis(3-aminopropyl)disiloxane
DAE: 4,4'-diaminodiphenylether
PDA: *p*-phenylenediamine
DBAB: 4,4'-diaminobenzanilide
m-TB: 4,4'-dimethylbenzidine
NMP: N-methyl-2-pyrrolidone

Production Example 1

To a reaction kettle equipped with a thermometer, dry nitrogen inlet, heating and cooling systems using hot and cooling water, and a stirrer, 12.43g (0.05mol) of SiDA, 50.05g (0.25mol) of DAE and 75.67g (0.7mol) of PDA were fed together with 2450 g of NMP. After dissolving the materials, 294.2g (1mol) of BPDA was added, and the resulting mixture was allowed to react at 70°C for 6 hours to obtain a polyamic acid resin solution (PA1) having a concentration of 15% by weight. The resin obtained by imidation of the polyamic acid resin solution (PA1) had a coefficient of linear expansion of 20 ppm/°C. a percentage of water absorption of 1.1 wt% and a glass transition temperature of 283°C.

Production Examples 2-7

The same operations as in Production Example 1 were repeated except that the types and the fed amounts of the acid dianhydride and diamine were changed as shown in Table 1 to obtain polyamic acid resin solutions (PA2-7) having a concentration of 15% by weight. The coefficients of linear expansion, percentages of water absorption and the glass transition temperatures of the resins obtained by imidizing the polyamic acid resin solutions (PA2-7) are shown in Table 1.

Production Example 8

The same operations as in Production Example 1 were repeated except that the types and the fed amounts of the acid dianhydride and diamine were changed as shown in Table 1 to obtain a polyamic acid resin solution (PA8) having a concentration of 15% by weight. The coefficient of linear expansion, percentage of water absorption and the glass transition temperature of the resin obtained by imidizing the polyamic acid resin solution (PA8) are shown in Table 1.

Table 1

| Upper row: Number of moles (mol)/Lower row: Fed amounts (g) | | | | | | | | | | | | |
|---|---|---|---|---|---|---|---|---|---|---|---|---|
| | | Tetracarboxylic Acid Component | | Diamine Component | | | | | Solvent DMAc | Coefficient of Linear Expansion (ppm/°C) | Percentage of Water Absorption (wt%) | Glass Transition Temperature (°C) |
| | | BPDA | OPDA | SiDA | DAE | PDA | DABA | m-TB | | | | |
| Production Example 1 | PA 1 | 1.00<br>294.20 | | 0.05<br>12.43 | 0.25<br>50.05 | 0.70<br>75.67 | | | 2450 | 20 | 1.1 | 283 |
| Production Example 2 | PA2 | 1.00<br>294.20 | | | 0.40<br>80.08 | 0.60<br>64.86 | | | 2488 | 20 | 1.6 | 295 |
| Production Example 3 | PA3 | 1.00<br>294.20 | | 0.05<br>12.43 | 0.35<br>70.07 | | 0.60<br>136.38 | | 2907 | 18 | 1.2 | 304 |
| Production Example 4 | PA4 | 1.00<br>294.20 | | | 0.80<br>160.16 | 0.20<br>21.62 | | | 2697 | 42 | 1.8 | 310 |
| Production Example 5 | PA5 | 1.00<br>294.20 | | 0.05<br>12.43 | 0.75<br>150.15 | | 0.20<br>45.46 | | 2846 | 39 | 1.1 | 298 |
| Production Example 6 | PA6 | | 1.00<br>310.20 | 0.10<br>24.85 | 0.90<br>180.18 | | | | 2920 | 68 | 1.0 | 254 |
| Production Example 7 | PA7 | 0.70<br>205.90 | 0.30<br>93.10 | 0.40<br>99.40 | 0.60<br>120.12 | | | | 2938 | 89 | 0.4 | 192 |

(continued)

| Upper row: Number of moles (mol)/Lower row: Fed amounts (g) | | | | | | | | | | | | |
|---|---|---|---|---|---|---|---|---|---|---|---|---|
| | | Tetracarboxylic Acid Component | | Diamine Component | | | | | Solvent DMAc | Coefficient of Linear Expansion (ppm/°C) | Percentage of Water Absorption (wt%) | Glass Transition Temperature (°C) |
| | | BPDA | OPDA | SiDA | DAE | PDA | DABA | m-TB | | | | |
| Production Example 8 | PA8 | 1.00<br>294.20 | | | 0.20<br>40.04 | 0.40<br>43.24 | | 0.40<br>84.92 | 2620 | 16 | 1.4 | 291 |

BPDA 3,3',4,4'-biphenyltetracarboxylic dianhydride
OPDA 3,3',4,4'-diphenylether tetracarboxylic dianhydride
SiDA 1,13,3-tetramethyl-1,3-bis(3-aminopropyl)disiloxane
DAE 4,4'-diaminodiphenylether
PDA *p*-phenylenediamine
DABA 4,4'-diaminobenzanilide
DMAc N,N-dimethylacetamide
m-TB 2,2'-dimethylbenzidine

Production Example 9

In 680 g of isopropyl alcohol and 1760 g of chlorobenzene, 250 g (50% by weight) of a polyamide resin "MACROMELT" produced by Henkel Japan Co., Ltd., 105 g (21% by weight) of an epoxy resin "EPIKOTE" 828 produced by Yuka Shell Epoxy K.K., and 145 g (29% by weight) of a phenol resin CKM-136 produced by Showa Highpolymer Co., Ltd. were dissolved to obtain a polyamide/epoxy/phenol heat-resistant resin solution (EP1). The resin obtained by thermally curing this polyamide/epoxy/phenol heat-resistant resin solution (EP1) at 160°C had a coefficient of linear expansion of not less than 100 ppm/°C, percentage of water absorption of 1.1 wt% and glass transition temperature of 62°C.

Example 1

The polyamic acid resin solution PA1 was coated on a polyimide film (KAPTON" 100EN produced by Du Pont-Toray Co., Ltd., Constituting Components: PMDA/BPDA/DAE/PDA, having no clear glass transition point at a temperature not higher than 500°C) having a thickness of 25 μm, which had been preliminarily subjected to low temperature plasma treatment under argon atmosphere with a reverse coater to a thickness after drying of 3 μm, and the coated film was dried at 80°C for 10 minutes and then at 140°C for another 10 minutes. This coated product was heat-treated under nitrogen atmosphere at 290°C for 5 minutes to carry out imidation and removal of the residual solvent, thereby obtaining a polyimide film/heat-resistant resin layer laminate.

On the heat-resistant resin layer of the thus prepared polyimide film/heat-resistant resin layer laminate, a surface-roughened copper foil (TQ-VLP, produced by Mitsui Mining & Smelting Co., Ltd.) having a thickness of 12 μm was laminated such that the roughened surface contacts the heat-resistant resin layer. The resulting laminate was heat pressed with a heated roll laminator having a surface temperature of the rolls of 380°C at a line pressure of 70 N/mm and a rate of I m/min such that polyimide films ("KAPTON" 500H produced by Du Pont-Toray Co., Ltd.) having a thickness of 125 μm as protective films were interposed between a roll and the polyimide film/heat-resistant resin layer laminate and between a roll and the copper foil, respectively, as shown in Fig. 5(a), thereby obtaining a single-sided copper clad laminate film. The warp of the obtained single-sided copper clad laminate film was 0 mm. The adhesion force was 7N/cm.

Examples 2 and 3

The same operations as in Example 1 were repeated except that the types and film thicknesses of the polyimide film, copper foil and the heat-resistant resin layer were changed as shown in Table 2, to obtain single-sided copper clad laminate films. The results of evaluation of warping of the obtained single-sided copper clad laminate films are summarized in Table 2.

The polyimide films used here were "KAPTON" 100EN produced by Du Pont-Toray Co., Ltd. (thickness: 25 μm), and "UPILEX" 25S produced by Ube Industries, Ltd. (Constituting Components: BPDA/PDA, having no clear glass transition point at a temperature not higher than 500°C) (thickness: 25 μm). The copper foils were a single surface-roughened copper foil TQ-VLP (thickness: 12 μm) produced by Mitsui Mining & Smelting Co., Ltd., a single surface-roughened copper foil F1-WS (thickness: 12 μm) produced by Furukawa Circuit Foil Co., Ltd., and a copper foil having smooth surfaces FO-WS (thickness: 12 μm) produced by Furukawa Circuit Foil Co., Ltd.
"KAPTON" 100EN has a coefficient of linear expansion of 17 ppm/°C and "UPILEX" has a coefficient of linear expansion of 14 ppm/°C.

Comparative Examples 1 and 2

The same operations as in Example 1 were repeated except that the types and film thicknesses of the polyimide film, copper foil and the heat-resistant resin layer were changed as shown in Table 2, to obtain single-sided copper clad laminate films. The results of evaluation of warping of the obtained single-sided copper clad laminate films are summarized in Table 2.

Table 2

| | Polyimide Film | Coefficient of Linear Expansion of Polyimide Film k (ppm/°C) | Copper Foil | Heat-resistant Resin Layer | | | Warp (mm) | Adhesion Force (N/cm) |
|---|---|---|---|---|---|---|---|---|
| | | | | Type | Coefficient of Linear Expansion kA (ppm/°C) | Film Thickness (μm) | | |
| Example 1 | Kapton 100EN | 17 | TQ-VLP | PA 1 | 20 | 3 | 0 | 7 |
| Example 2 | Upilex 25S | 14 | FI-WS | PA 1 | 20 | 5 | 0 | 7 |
| Example 3 | Kapton 100EN | 17 | TQ-VLP | PA2 | 20 | 2 | 0 | 6 |
| Comparative Example 1 | Kapton 100EN | 17 | TQ-VLP | PA4 | 42 | 3 | >20 | 10 |
| Comparative Example 2 | Upilex 25S | 14 | F1-WS | PA6 | 68 | 5 | >20 | 10 |

Example 4

The polyamic acid resin solution PA1 was coated on a roughened surface of a copper foil (TQ-VLP produced by Mitsui Mining & Smelting Co., Ltd.) having a thickness of 12 μm with a reverse coater to a thickness after drying of 3 μm, and the coated film was dried at 80°C for 10 minutes and then at 140°C for another 10 minutes. This coated product was heat-treated under nitrogen atmosphere at 290°C for 5 minutes to carry out imidation and removal of the residual solvent, thereby obtaining a copper foil/heat-resistant resin layer A laminate.

Similarly, the polyamic acid resin solution PA7 was coated on a polyimide film (KAPTON" 100EN produced by Du Pont-Toray Co., Ltd.) having a thickness of 25 μm, which had been preliminarily subjected to low temperature plasma treatment under argon atmosphere, with a reverse coater to a thickness after drying of 3 μm, and the coated film was dried at 80°C for 10 minutes and then at 140°C for another 10 minutes. This coated product was heat-treated under nitrogen atmosphere at 290°C for 5 minutes to carry out imidation and removal of the residual solvent, thereby obtaining a polyimide film/heat-resistant resin layer B laminate.

The thus prepared copper foil/heat-resistant resin layer A laminate and the polyimide film/heat-resistant resin layer B laminate were laminated such that the heat-resistant resin layer A and heat-resistant resin layer B face each other. The resulting laminate was heat pressed with a heated roll laminator having a surface temperature of the rolls of 350°C at a line pressure of 50 N/mm and a rate of 2 m/min such that polyimide films ("KAPTON" 500H produced by Du Pont-Toray Co., Ltd.) having a thickness of 125 μm as protective films were interposed between a roll and the copper foil/heat-resistant resin layer A laminate and between a roll and the polyimide film/heat-resistant resin layer B laminate, respectively, as shown in Fig. 5(a), thereby obtaining a single-sided copper clad laminate film. The warp of the obtained single-sided copper clad laminate film was 0 mm. The adhesion force was 11 N/cm.

Examples 5-9

The same operations as in Example 4 were repeated except that the type and film thickness of the polyimide film, copper foil, the heat-resistant resin layer A and heat-resistant resin layer B were changed as shown in Table 3, to obtain single-sided copper clad laminate films. The results of evaluation of warping of the obtained single-sided copper clad laminate films are summarized in Table 3.

Comparative Examples 3-5

The same operations as in Example 4 were repeated except that the type and film thickness of the polyimide film, copper foil, the heat-resistant resin layer A and heat-resistant resin layer B were changed as shown in Table 3, to obtain single-sided copper clad laminate films. The results of evaluation of warping of the obtained single-sided copper clad laminate films are summarized in Table 3.

Table 3

| | Copper Foil | Heat-resistant Resin Layer A | | | Polyimide Film | Coefficient of Linear Expansion of Polyimide Film k (ppm/°C) | Heat-resistant Resin Layer B | | | Warp (mm) | Adhesion Force (N/cm) |
|---|---|---|---|---|---|---|---|---|---|---|---|
| | | Type | Coefficient of Linear Expansion kA (ppm/°C) | Film Thickness (μm) | | | Type | Coefficient of Linear Expansion (ppm/°C) | Film Thickness (μm) | | |
| Example 4 | TQ-VLP | PA 1 | 20 | 3 | Kapton 100EN | 17 | PA7 | 89 | 1 | 0 | 11 |
| Example 5 | FI-WS | PA 1 | 20 | 5 | Upilex 25S | 14 | PA6 | 68 | 2 | 0 | 11 |
| Example 6 | TQ-VLP | PA2 | 20 | 3 | Kapton 100EN | 17 | PA6 | 68 | 1 | 0 | 10 |
| Example 7 | TQ-VLP | PA2 | 20 | 5 | Upilex 25S | 14 | PA6 | 68 | 3 | 3 | 10 |
| Example 8 | F0-WS | PA3 | 18 | 2 | Kapton 100EN | 17 | PA6 | 68 | 1 | 0.1 | 10 |
| Example 9 | TQ-VLP | PA3 | 18 | 3 | Kapton 100EN | 17 | PA7 | 89 | 1 | 0 | 11 |
| Comparative Example 3 | TQ-VLP | PA4 | 42 | 3 | Kapton 100EN | 17 | PA7 | 89 | 1 | >20 | 10 |
| Comparative Example 4 | FI-WS | PA5 | 39 | 5 | Kapton 100EN | 17 | PA6 | 68 | 2 | >20 | 10 |
| Comparative Example 5 | TQ-VLP | PA6 | 68 | 2 | Upilex 25S | 14 | PA6 | 68 | 1 | >20 | 10 |

Example 10

The polyamic acid resin solution PA1 was coated on a roughened surface of a copper foil (TQ-VLP produced by Mitsui Mining & Smelting Co., Ltd.) having a thickness of 12 μm with a reverse coater to a thickness after drying of 3 μm, and the coated film was dried at 80°C for 10 minutes and then at 140°C for another 10 minutes to obtain a copper foil/heat-resistant resin layer A laminate.

Similarly, the polyamic acid resin solution PA7 was coated on a polyimide film ("KAPTON" 100EN produced by Du Pont-Toray Co., Ltd.) having a thickness of 25 μm, which had been preliminarily subjected to low temperature plasma treatment under argon atmosphere, with a reverse coater to a thickness after drying of 1 μm, and the coated film was dried at 80°C for 10 minutes and then at 140°C for another 10 minutes, to obtain a polyimide film/heat-resistant resin layer B laminate.

The thus prepared copper foil/heat-resistant resin layer A laminate and the polyimide film/heat-resistant resin layer B laminate were laminated such that the heat-resistant resin layer A and heat-resistant resin layer B face each other. The resulting laminate was heat pressed with a heated roll laminator having a surface temperature of the rolls of 200°C at a line pressure of 10 N/mm and a rate of 1 m/min. Then the resulting laminate film was heated stepwise [(80°C, 30 minutes) + (150°C, 1 hour) + (280°C, 2 hours)] under nitrogen atmosphere to carry out imidation of the heat-resistant resin layers, and the resulting film was slowly cooled to room temperature, to obtain a single-sided copper clad laminate film. The warp of the obtained single-sided copper clad laminate film was 0 mm. The adhesion force was 12 N/cm.

Examples 11-13

The same operations as in Example 10 were repeated except that the types and film thicknesses of the polyimide film, copper foil, the heat-resistant resin layer A and heat-resistant resin layer B were changed as shown in Table 4, to obtain single-sided copper clad laminate films. The results of evaluation of warping of the obtained single-sided copper clad laminate films are summarized in Table 4.

Example 14

The same operations as in Example 10 were repeated except that the types and film thicknesses of the polyimide film, copper foil, the heat-resistant resin layer A and heat-resistant resin layer B were changed as shown in Table 4, to obtain single-sided copper clad laminate films. The results of evaluation of warping of the obtained single-sided copper clad laminate films are summarized in Table 4.

Comparative Examples 6-8

The same operations as in Example 4 were repeated except that the types and film thicknesses of the polyimide film, copper foil, the heat-resistant resin layer A and heat-resistant resin layer B were changed as shown in Table 4, to obtain single-sided copper clad laminate films. The results of evaluation of warping of the obtained single-sided copper clad laminate films are summarized in Table 4.

Table 4

| | Copper Foil | Heat-resistant Resin Layer A | | | Polyimide Film | Coefficient of Linear Expansion of Polyimide Film k (ppm/°C) | Heat-resistant Resin Layer B | | | Warp (mm) | Adhesion Force (N/cm) |
|---|---|---|---|---|---|---|---|---|---|---|---|
| | | Type | Coefficient of Linear Expansion kA (ppm/°C) | Film Thickness (μm) | | | Type | Coefficient of Linear Expansion (ppm/°C) | Film Thickness (μm) | | |
| Example 10 | TQ-VLP | PA 1 | 20 | 3 | Kapton 100EN | 17 | PA 7 | 89 | 1 | 0 | 12 |
| Example 1I | TQ-VLP | PA 1 | 20 | 3 | Kapton 100EN | 17 | PA 7 | 89 | 3 | 3 | 12 |
| Example 12 | FI-WS | PA2 | 20 | 4 | Upilex 25S | 14 | PA 7 | 89 | 2 | 0.1 | 11 |
| Example 13 | F0-WS | PA3 | 18 | 5 | Kapton 100EN | 17 | PA 7 | 89 | 2 | 0 | 11 |
| Example 14 | TQ-VLP | PA8 | 16 | 4 | Kapton 100EN | 17 | PA 7 | 89 | 2 | 0 | 11 |
| Comparative Example 6 | TQ-VLP | PA4 | 42 | 3 | Kapton 100EN | 17 | PA 7 | 89 | 1 | >20 | 11 |
| Comparative Example 7 | TQ-VLP | PA5 | 39 | 5 | Upilex 25S | 14 | PA 7 | 89 | 2 | >20 | 11 |
| Comparative Example 8 | TQ-VLP | PA6 | 68 | 4 | Kapton 100EN | 17 | PA 7 | 89 | 2 | >20 | 11 |

Example 15

The polyamic acid resin solution PA1 was coated on a polyimide film ("KAPTON" 100EN produced by Du Pont-Toray Co., Ltd.) having a thickness of 25 μm, which had been preliminarily subjected to low temperature plasma treatment under argon atmosphere, with a reverse coater to a thickness after drying of 3 μm, and the coated film was dried at 80°C for 10 minutes and then at 140°C for another 10 minutes. On the thus formed coating layer, the polyamic acid resin solution PA6 was applied with a reverse coater to a thickness after drying of 1 μm, and the coated film was dried at 80°C for 10 minutes and then at 140°C for another 10 minutes. This coated product was heat-treated under nitrogen atmosphere at 290°C for 5 minutes to carry out imidation and removal of the residual solvent, thereby obtaining a polyimide film/ heat-resistant resin layer A/heat-resistant resin layer B laminate.

The thus prepared polyimide film/ heat-resistant resin layer A/heat-resistant resin layer B laminate and a copper foil (TQ-VLP produced by Mitsui Mining & Smelting Co., Ltd.) having a thickness of 12 μm were laminated such that the heat-resistant resin layer B and the roughened surface of the copper foil face each other. The resulting laminate was heat pressed with a heated roll laminator having a surface temperature of the rolls of 350°C at a line pressure of 50 N/mm and a rate of 2 m/min such that polyimide films ("KAPTON" 500H produced by Du Pont-Toray Co., Ltd.) having a thickness of 125 μm as protective films were interposed between a roll and the polyimide film/polyimide resin layer laminate and between a roll and the copper foil, respectively, as shown in Fig. 5, thereby obtaining a single-sided copper clad laminate film. The warp of the obtained single-sided copper clad laminate film was 3 mm. The adhesion force was 10 N/cm.

Example 16

The polyamic acid resin solution PA6 was coated on a roughened surface of a copper foil (TQ-VLP produced by Mitsui Mining & Smelting Co., Ltd.) having a thickness of 12 μm with a reverse coater to a thickness after drying of 0.5 μm, and the coated film was dried at 80°C for 10 minutes and then at 140°C for another 10 minutes. On the thus formed coating layer, the polyamic acid resin solution PA1 was applied with a reverse coater to a thickness after drying of 3 μm, and the coated film was dried at 80°C for 10 minutes and then at 140°C for another 10 minutes. This coated product was heat-treated under nitrogen atmosphere at 290°C for 5 minutes to carry out imidation and removal of the residual solvent, thereby obtaining a copper foil/heat-resistant resin layer B/heat-resistant resin layer A laminate.

Similarly, the polyamic acid resin solution PA7 was coated on a polyimide film ("KAPTON" 100EN produced by Du Pont-Toray Co., Ltd.) having a thickness of 25 μm, which had been preliminarily subjected to low temperature plasma treatment under argon atmosphere, with a reverse coater to a thickness after drying of 1 μm, and the coated film was dried at 80°C for 10 minutes and then at 140°C for another 10 minutes. This coated product was heat-treated under nitrogen atmosphere at 290°C for 5 minutes to carry out imidation and removal of the residual solvent, thereby obtaining a polyimide film/heat-resistant resin layer B laminate.

The thus prepared copper foil/heat-resistant resin layer B/heat-resistant resin layer A laminate and the polyimide film/heat-resistant resin layer B laminate were laminated such that the heat-resistant resin layer A of the copper foil/ heat-resistant resin layer B/heat-resistant resin layer A laminate and the heat-resistant resin layer B of the polyimide film/heat-resistant resin layer B laminate face each other. The resulting laminate was heat pressed with a heated roll laminator having a surface temperature of the rolls of 350°C at a line pressure of 50 N/mm and a rate of 2 m/min such that polyimide films ("KAPTON" 500H produced by Du Pont-Toray Co., Ltd.) having a thickness of 125 μm as protective films were interposed between a roll and the copper foil/heat-resistant resin layer B/heat-resistant resin layer A laminate and between a roll and the polyimide film/heat-resistant resin layer B laminate, respectively, as shown in Fig. 5, thereby obtaining a single-sided copper clad laminate film. The warp of the obtained single-sided copper clad laminate film was 0.2 mm. The adhesion force was 12 N/cm.

Example 17

The polyamic acid resin solution PA7 was coated on a roughened surface of a copper foil (TQ-VLP produced by Mitsui Mining & Smelting Co., Ltd.) having a thickness of 12 μm with a reverse coater to a thickness after drying of 0.3 μm, and the coated film was dried at 80°C for 10 minutes and then at 140°C for another 10 minutes. On the thus formed coating layer, the polyamic acid resin solution PA1 was applied with a reverse coater to a thickness after drying of 3 μm, and the coated film was dried at 80°C for 10 minutes and then at 140°C for another 10 minutes, to obtain a copper foil/heat-resistant resin layer B/heat-resistant resin layer A laminate.

Similarly, the polyamic acid resin solution PA7 was coated on a polyimide film ("KAPTON" 100EN produced by Du Pont-Toray Co., Ltd.) having a thickness of 25 μm, which had been preliminarily subjected to low temperature plasma treatment under argon atmosphere, with a reverse coater to a thickness after drying of I μm, and the coated film was dried at 80°C for 10 minutes and then at 140°C for another 10 minutes, to obtain a polyimide film/heat-resistant

resin layer B laminate.

The thus prepared copper foil/heat-resistant resin layer B/heat-resistant resin layer A laminate and the polyimide film/heat-resistant resin layer B laminate were laminated such that the heat-resistant resin layer A of the copper foil/ heat-resistant resin layer B/heat-resistant resin layer A laminate and the heat-resistant resin layer B of the polyimide film/heat-resistant resin layer B laminate face each other. The resulting laminate was heat pressed with a heated roll laminator having a surface temperature of the rolls of 200°C at a line pressure of 10 N/mm and a rate of 1 m/min. Then the resulting laminate film was heated stepwise [(80°C, 30 minutes) + (150°C, I hour) + (280°C, 2 hours)] under nitrogen atmosphere to carry out imidation of the heat-resistant resin layers, and the resulting film was slowly cooled to room temperature, to obtain a single-sided copper clad laminate film. The warp of the obtained single-sided copper clad laminate film was 0.1 mm. The adhesion force was 14 N/cm.

Example 18

The polyamic acid resin solution PA 1 was coated on a roughened surface of a copper foil (TQ-VLP produced by Mitsui Mining & Smelting Co., Ltd.) having a thickness of 12 μm with a reverse coater to a thickness after drying of 5 μm, and the coated film was dried at 80°C for 10 minutes and then at 140°C for another 10 minutes. This coated product was heat-treated under nitrogen atmosphere at 290°C for 5 minutes to carry out imidation and removal of the residual solvent, thereby obtaining a copper foil/heat-resistant resin layer A laminate.

Then the polyamide/epoxy/phenol heat-resistant resin solution (EP1) was coated on a polyimide film ("UPILEX" 25S produced by Ube Industries, Ltd.) having a thickness of 25 μm, which had been preliminarily subjected to low temperature plasma treatment under argon atmosphere, with a reverse coater to a thickness after drying of 2 μm, and the coated film was dried at 80°C for 10 minutes and then at 120°C for another 10 minutes, to obtain a polyimide film/ heat-resistant resin layer B laminate.

The thus prepared copper foil/heat-resistant resin layer A laminate and the polyimide film/heat-resistant resin layer B laminate were laminated such that the heat-resistant resin layer A of the copper foil/ heat-resistant resin layer A laminate and the heat-resistant resin layer B of the polyimide film/heat-resistant resin layer B laminate face each other. The resulting laminate was heat pressed with a heated roll laminator having a surface temperature of the rolls of 140°C at a line pressure of 6 N/mm and a rate of 1 m/min. Then the resulting laminate film was heated stepwise [(80°C, 30 minutes) + (120°C, 1 hour) + (160°C, 2 hours)] under nitrogen atmosphere to thermally cure the heat-resistant resin layer B, and the resulting film was slowly cooled to room temperature, to obtain a single-sided copper clad laminate film. The warp of the obtained single-sided copper clad laminate film was 0 mm. The adhesion force was 11 N/cm.

Example 19

The polyamic acid resin solution PA8 was coated on a roughened surface of a copper foil (TQ-VLP produced by Mitsui Mining & Smelting Co., Ltd.) having a thickness of 12 μm with a reverse coater to a thickness after drying of 5 μm, and the coated film was dried at 80°C for 10 minutes and then at 140°C for another 10 minutes, to obtain a copper foil/heat-resistant resin layer A laminate.

Then the polyamide/epoxy/phenol heat-resistant resin solution (EP1) was coated on a polyimide film ("KAPTON" 100EN produced by Du Pont-Toray Co., Ltd.) having a thickness of 25 μm, which had been preliminarily subjected to low temperature plasma treatment under argon atmosphere, with a reverse coater to a thickness after drying of 2 μm, and the coated film was dried at 80°C for 10 minutes and then at 120°C for another 10 minutes, to obtain a polyimide film/heat-resistant resin layer B laminate.

The thus prepared copper foil/heat-resistant resin layer A laminate and the polyimide film/heat-resistant resin layer B laminate were laminated such that the heat-resistant resin layer A of the copper foil/heat-resistant resin layer A laminate and the heat-resistant resin layer B of the polyimide film/heat-resistant resin layer B laminate face each other. The resulting laminate was heat pressed with a heated roll laminator having a surface temperature of the rolls of 140°C at a line pressure of 6 N/mm and a rate of 1 m/min. Then the resulting laminate film was heated stepwise [(80°C, 30 minutes) + (150°C, 1 hour) + (280°C, 1 hour)] under nitrogen atmosphere to carry out imidation of the heat-resistant resin layers, and the resulting film was slowly cooled to room temperature, to obtain a single-sided copper clad laminate film. The warp of the obtained single-sided copper clad laminate film was 0 mm. The adhesion force was I N/cm.

As seen from the above-described results, the heat-resistant resin laminate film according to the present invention did not warp in either of the state in which a metal layer was laminated, or the metal layer was entirely etched. In contrast, in Comparative Examples, although the laminate films did not warp in the state in which a metal layer was laminated, a large warp occurred and the sample was rolled into cylindrical shape in the state in which the metal layer was entirely etched.

Example 20

On the copper layer of the single-sided copper clad laminate film obtained in Example 1, a photoresist layer was applied with a reverse coater to a thickness after drying of 4 μm, and dried. The photoresist layer was exposed through a mask and developed with an alkaline solution to form a circuit pattern. The copper foil was then subjected to wet etching treatment with aqueous ferric chloride solution, and the remaining photoresist layer was removed to form a copper circuit pattern. On the thus formed copper circuit pattern, tin was plated to a thickness of 0.4 μm by electroless plating, and then a solder resist was coated on the circuit pattern to obtain a COF tape. The COF tape did not warp.

A semiconductor chip having gold bumps was bonded to the inner lead of the thus obtained COF tape by the flip chip mounting, and the resulting chip was sealed with a resin to obtain a semiconductor device. Since the COF tape had no warp, the number of defects due to the imperfect bonding or the like was small, and the semiconductor device had high reliability.

Example 21

The same operations as in Example 20 were repeated except that the copper clad laminate film obtained in Example 6 was used. The COF tape did not warp, and the semiconductor device prepared therefrom showed high reliability without short-circuit in the wirings.

Example 22

The same operations as in Example 20 were repeated except that the copper clad laminate film obtained in Example 13 was used. The COF tape did not warp, and the semiconductor device prepared therefrom showed high reliability without short-circuit in the wirings.

**Claims**

1. A heat-resistant resin laminate film comprising a heat-resistant insulating film, and a heat-resistant resin layer(s) laminated on at least one surface of said heat-resistant insulating film, said heat-resistant resin layer having a coefficient of linear expansion kA (ppm/°C) within the range of $k-10 \leq kA \leq k+20$ (wherein k represents the coefficient of linear expansion of said heat-resistant insulating film).

2. The heat-resistant resin laminate film according to claim 1, comprising a heat-resistant insulating film, and a heat-resistant resin layer(s) laminated on at least one surface of said heat-resistant insulating film, wherein said heat-resistant resin layer comprises not less than two heat-resistant resin layers at least one of which has a coefficient of linear expansion kA (ppm/°C) within the range of $k-10 \leq kA \leq k+20$ (wherein k represents the coefficient of linear expansion of said heat-resistant insulating film).

3. The heat-resistant resin laminate film according to claim 1 or 2, wherein said heat-resistant insulating film has a coefficient of linear expansion of 5 to 25 ppm/°C, and said heat-resistant resin layer having the coefficient of linear expansion kA (ppm/°C) within the range of $k-10 < kA < k+20$ (wherein k represents the coefficient of linear expansion of said heat-resistant insulating film) has a coefficient of linear expansion of 5 to 30 ppm/°C.

4. The heat-resistant resin laminate film according to any one of claims 1 to 3, wherein the resin constituting said heat-resistant resin layer having the coefficient of linear expansion kA (ppm/°C) within the range of $k-10 < kA < k+20$ (wherein k represents the coefficient of linear expansion of said heat-resistant insulating film) is a polyimide resin comprising as a diamine component(s) at least one aromatic diamine represented by any of the Formulae (1) to (3) in an amount of not less than 40 mol% based on the total diamine component(s).

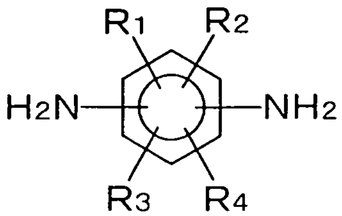

(1)

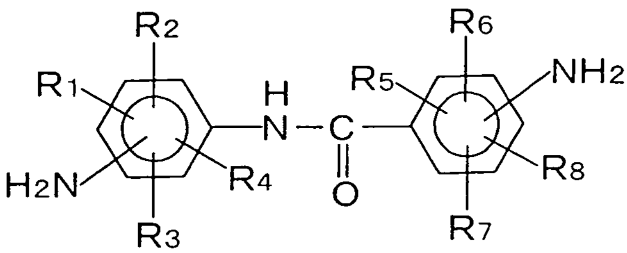

(2)

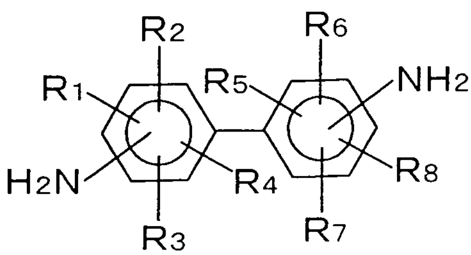

(3)

(wherein $R^1$ to $R^8$, the same or different, are selected from the group consisting of hydrogen. $C_1$-$C_{30}$ alkyl, $C_1$-$C_{30}$ alkoxy, halogen, hydroxy, carboxyl, sulfonic, nitro and cyano).

**5.** The heat-resistant resin laminate film according to claim 4, wherein said diamine component(s) of said polyimide resin comprises at least one selected from the group consisting of *p*-phenylenediamine, 4,4'-diaminobenzanilide and 2,2'-dimethylbenzidine, in an amount of not less than 40 mol% based on the total diamine component(s).

**6.** The heat-resistant resin laminate film according to claim 4, wherein tetracarboxylic acid component(s) of said polyimide resin comprise pyromellitic dianhydride and/or biphenyltetracarboxylic dianhydride in an amount of not less than 40 mol% based on the total tetracarboxylic acid component(s).

**7.** A laminate film having a metal layer(s), comprising said heat-resistant resin laminate film according to any one of claims I to 6, and a metal layer(s) laminated on said heat-resistant resin layer(s).

**8.** The laminate film having a metal layer(s) according to claim 7, comprising said heat-resistant insulating film and said metal layer(s) laminated on at least one surface of said heat-resistant insulating film through said heat-resistant resin layer, wherein said heat-resistant resin layer comprises at least two layers including said heat-resistant resin layer A whose coefficient of linear expansion kA (ppm/°C) is within the range of $k-10<kA<k+20$ (wherein k represents the coefficient of linear expansion of said heat-resistant insulating film) and a heat-resistant resin layer B having a glass transition temperature lower than that of said heat-resistant resin layer A, said heat-resistant resin layer A being laminated at a side so as to contact said metal layer, and said heat-resistant resin layer B being laminated at a side so as to contact said heat-resistant insulating film.

9. The laminate film having a metal layer(s) according to claim 8, wherein said heat-resistant resin layer A has a glass transition temperature of 250°C to 400°C.

10. The laminate film having a metal layer(s) according to claim 8 or 9, wherein said heat-resistant resin layer A has a thickness of not less than twice that of said heat-resistant resin layer B.

11. The laminate film having a metal layer(s) according to any one of claims 8 to 10, wherein said heat-resistant resin layer B consists essentially of a polyimide resin(s).

12. The laminate film having a metal layer(s) according to claim 11, wherein said heat-resistant resin layer B has a glass transition temperature of 120°C to 280°C.

13. The laminate film having a metal layer(s) according to any one of claims 8 to 10, wherein said heat-resistant resin layer B consists essentially of a thermosetting resin(s) containing an epoxy compound(s).

14. The laminate film having a metal layer(s) according to claim 13, wherein said heat-resistant resin layer B has a glass transition temperature of 50°C to 250°C.

15. A semiconductor device comprising said laminate film having a metal layer(s) according to any one of claims 6 to 14.

16. A process of producing a laminate film having a metal layer(s) comprising a heat-resistant insulating film and a metal layer(s) laminated on at least one surface of said heat-resistant insulating film through a heat-resistant resin layer (s), said process comprising the steps of laminating at least one heat-resistant resin layer including a heat-resistant resin layer having a coefficient of linear expansion kA (ppm/°C) within the range of $k-10 \leq kA \leq k+20$ (wherein k represents the coefficient of linear expansion of said heat-resistant insulating film) on said metal layer; laminating the resulting metal layer/heat-resistant resin layer laminate(s) and said heat-resistant insulating film which may, as required, have at least one heat-resistant resin layer; and heat pressing the resulting laminate.

17. A process of producing a laminate film having a metal layer(s) comprising a heat-resistant insulating film and a metal layer(s) laminated on at least one surface of said heat-resistant insulating film through a heat-resistant resin layer (s), said process comprising the steps of laminating at least one heat-resistant resin layer including a heat-resistant resin layer having a coefficient of linear expansion kA (ppm/°C) within the range of $k-10 \leq kA \leq k+20$ (wherein k represents the coefficient of linear expansion of said heat-resistant insulating film) on said heat-resistant insulating film; laminating the resulting heat-resistant insulating film/heat-resistant resin layer laminate and said metal layer(s) which may, as required, have at least one heat-resistant resin layer; and heat pressing the resulting laminate.

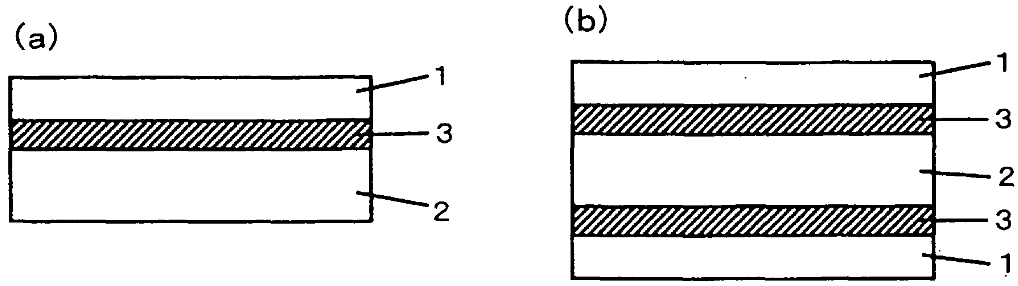


Fig.1

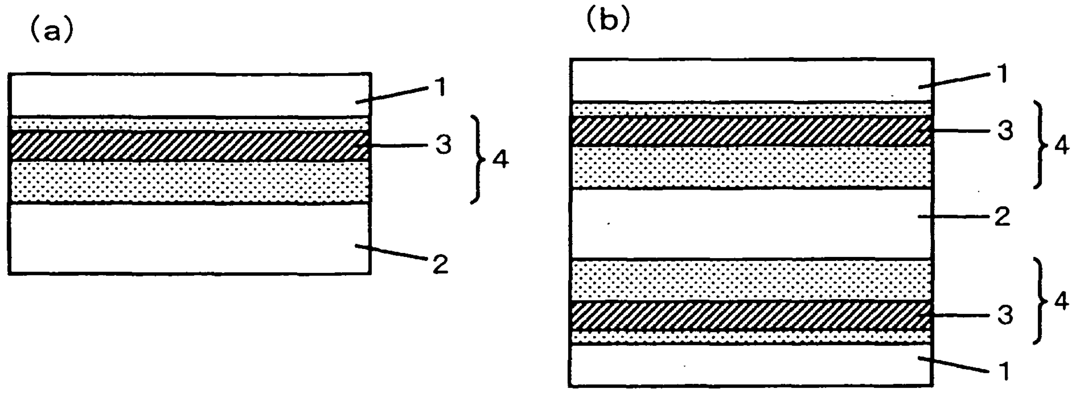


Fig.2

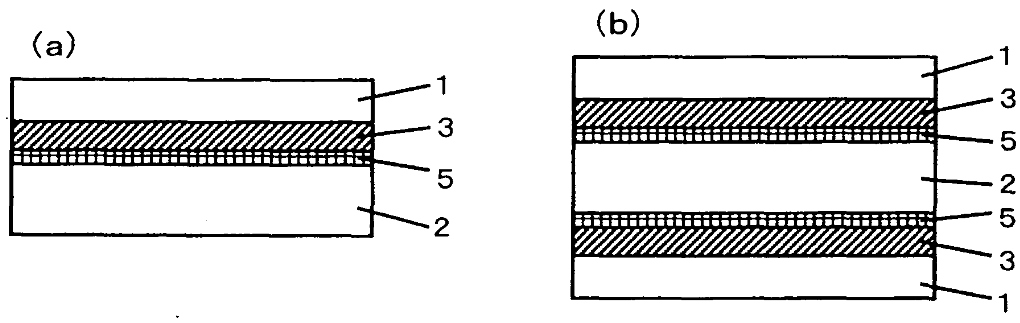


Fig.3

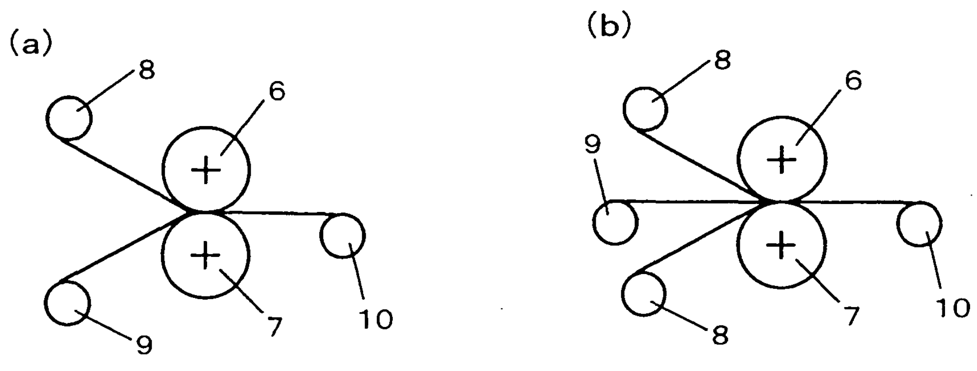


Fig.4

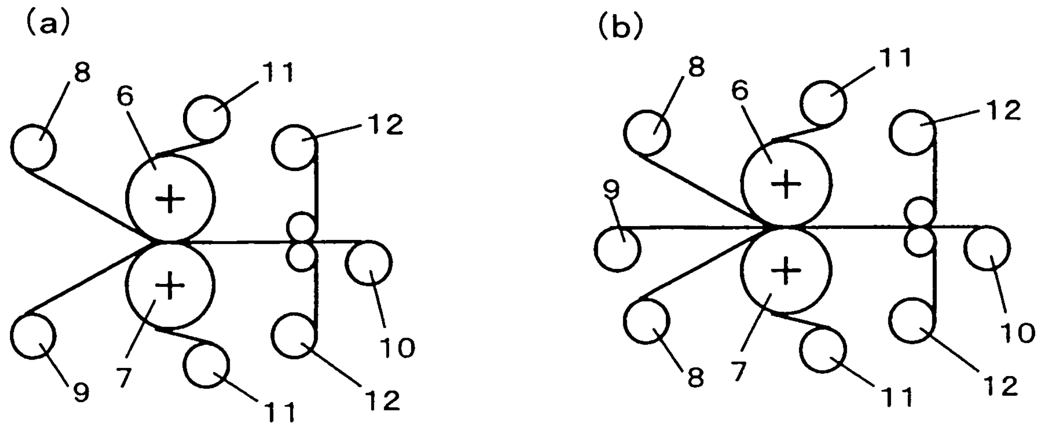


Fig.5

## INTERNATIONAL SEARCH REPORT

International application No. PCT/JP2005/003380

A. CLASSIFICATION OF SUBJECT MATTER
Int.Cl$^7$ B32B27/34, 15/08, H05K1/03

According to International Patent Classification (IPC) or to both national classification and IPC

B. FIELDS SEARCHED

Minimum documentation searched (classification system followed by classification symbols)
Int.Cl$^7$ B32B27/34, 15/08, H05K1/03

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2000-22288 A (Sony Chemicals Corp.), 21 January, 2000 (21.01.00), (Family: none) | 1,3-7,15<br>2,8-14,16,17 |
| X<br>Y | JP 2000-151046 A (Sony Chemicals Corp.), 30 May, 2000 (30.05.00), (Family: none) | 1,3-7,15<br>2,8-14,16,17 |
| X<br>Y | JP 2000-188445 A (Sony Chemicals Corp.), 04 July, 2000 (04.07.00), (Family: none) | 1,3-7,15<br>2,8-14,16,17 |
| Y | JP 2000-43211 A (Ube Industries, Ltd.), 15 February, 2000 (15.02.00), (Family: none) | 2,8-14,17 |

☒ Further documents are listed in the continuation of Box C.　☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 07 June, 2005 (07.06.05) | 28 June, 2005 (28.06.05) |
| Name and mailing address of the ISA/<br>Japanese Patent Office | Authorized officer |
| Facsimile No. | Telephone No. |

Form PCT/ISA/210 (second sheet) (January 2004)

INTERNATIONAL SEARCH REPORT

International application No.
PCT/JP2005/003380

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2001-205734 A (Ube Industries, Ltd.), 31 July, 2001 (31.07.01), & US 2001/10860 A1 | 16 |
| X | JP 5-214301 A (Hitachi, Ltd.), 24 August, 1993 (24.08.93), (Family: none) | 1,3-7,15 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 9099518 A
- JP 2002114848 A
- JP 9148695 A
- JP 2000096010 A